(19) Europäisches Patentamt
European Patent Office
Office européen des brevets

(11) **EP 2 199 733 B1**

(12) **EUROPEAN PATENT SPECIFICATION**

(45) Date of publication and mention
of the grant of the patent:
**13.02.2013 Bulletin 2013/07**

(51) Int Cl.:
***G01B 7/34*** *(2006.01)*     ***H01F 27/42*** *(2006.01)*
***G01R 33/00*** *(2006.01)*

(21) Application number: **08021930.6**

(22) Date of filing: **17.12.2008**

(54) **Electric circuit and method of operating a measuring instrument**

Stromkreis und Verfahren zum Betreiben eines Messinstruments

Circuit électrique et procédé de fonctionnement d'un instrument de mesure

(84) Designated Contracting States:
**DE GB**

(43) Date of publication of application:
**23.06.2010 Bulletin 2010/25**

(73) Proprietors:
 • **Mitutoyo Corporation**
 **Kawasaki-shi**
 **Kanagawa-ken 213-8533 (JP)**
 • **Bundesrepublik Deutschland**
 **endvertreten durch den Präsidenten der**
 **Physikalisch-Technischen Bundesanstalt**
 **38116 Braunschweig (DE)**

(72) Inventors:
 • **Illers, Hartmut**
 **38729 Hahausen (DE)**

 • **Hidaka, Kazuhiko**
 **5684 PJ Best (NL)**
 • **Saito, Akinori**
 **Ibaraki-ken 305-0854 (JP)**
 • **Danzebrink, Dr.Hans-Ulrich**
 **38124 Braunschweig (DE)**

(74) Representative: **Grünecker, Kinkeldey,**
 **Stockmair & Schwanhäusser**
 **Leopoldstrasse 4**
 **80802 München (DE)**

(56) References cited:
 WO-A-2008/138873    DE-U1- 29 714 612
 GB-A- 2 388 914      US-A- 3 848 159
 US-A- 4 270 061      US-A- 5 274 704
 US-A- 5 477 135      US-A1- 2006 186 876
 US-B1- 6 566 854

**Description**

The present invention generally relates to the technical field of electric circuits, in particular to an interface circuit for a scanning force microscope, a phase shifter, an AC current to voltage converter, an AC voltage to voltage decoupler, an AC superposition circuit and an AC subtraction circuit. Moreover, the present invention relates to a measuring instrument, in particular to a scanning force microscope and to a method for the operation of a measuring instrument, in particular to a method of operating a scanning force microscope.

Scanning force microscopy allows the investigation of sample surfaces at resolutions which are higher than the resolution that may be obtained by means of optical microscopy. In contrast to other high resolution microscopy techniques such as electron microscopy, scanning force microscopy need not be performed in vacuum, but may be performed in ambient air, and can even be performed in liquids. In contrast to scanning tunneling microscopy, scanning force microscopy is not limited to electrically conductive samples. Moreover, scanning force microscopy may have a broader applicability than optical near field microscopy.

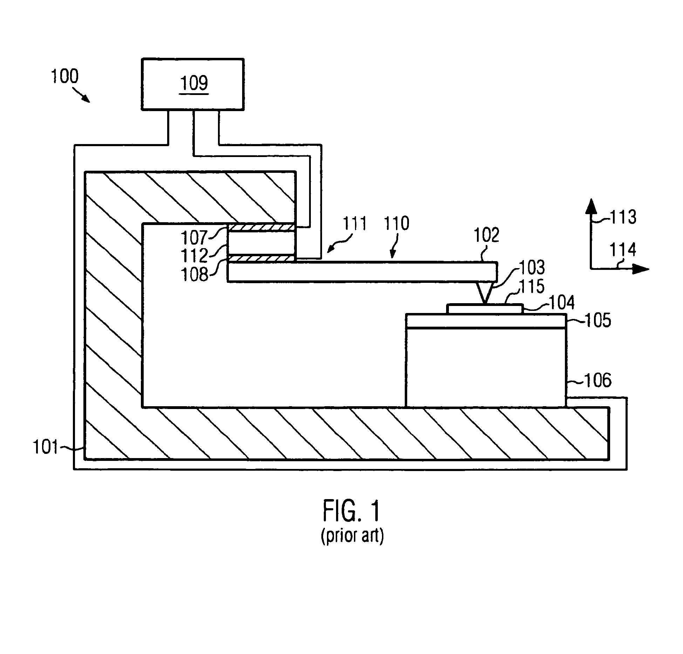

Fig. 1 shows a schematic cross-sectional view of a scanning force microscope 100 according to the state of the art. The scanning force microscope 100 comprises a sensor 110. The sensor 110 comprises a body which, in the scanning force microscope 100 shown in Fig. 1, is provided in form of a cantilever 102, and a measuring tip 103 provided adjacent an end of the cantilever 103. The cantilever 102 is connected to a holder structure 101 by means of an electromechanical element 111 that may comprise a piezoelectric material 112 and electrodes 107, 108 adapted for applying an electric voltage to the piezoelectric material 112.

The electromechanical element 111 need not be separate from the cantilever 102. In other examples of scanning force microscopes according to the state of the art, the cantilever 102 may be formed of a piezoelectric material, and the electrodes 107, 108 may be adapted for application of an electric voltage to the cantilever 102. Thus, the electromechanical element 111 and the body of the sensor 110 may be integral.

The scanning force microscope 100 further comprises a positioner 106 for moving a sample 104 provided in a sample holder 105 connected to the positioner relative to the sensor 110, and control electronics 109. The control electronics 109 may be configured to apply an electric voltage between the electrodes 107, 108 of the electromechanical element 111, to control the positioner 106 to move the sample holder 105 and the sample 104 relative to the sensor 110, and to analyze signals from the electromechanical element 111 and the positioner 106.

In the operation of the scanning force microscope 100, an AC voltage may be applied between the electrodes 107, 108 of the electromechanical element 111 to excite bending vibrations of the cantilever 102 such that the measuring tip 103 oscillates in a vertical direction 113, which may be substantially perpendicular to a surface 115 of the sample 104. A frequency of the AC voltage may be approximately equal to a resonance frequency of the cantilever 102. The control electronics 109 may detect the oscillation of the cantilever 102 by analyzing an electric current flowing through the electromechanical element 111 in response to the voltage applied thereto. In particular, an amplitude of the current and a phase difference between the current and the voltage may be measured.

The positioner 106 may move the sample 104 in the vertical direction 113 such that the measuring tip 103 approaches the sample surface 115 and the measuring tip 103 interacts with the sample surface 115. The interaction between the sample surface 115 and the measuring tip 103 may have an influence on the oscillation of the cantilever 102, which, in turn, may have an influence on the current flowing through the electromechanical element 111. A smaller distance between the measuring tip 103 and the sample surface 115 may lead to a stronger interaction between the measuring tip 103 and the sample surface 115, such that amplitude and/or phase of the current flowing through the electromechanical element 111 are modified to a greater extent. The control electronics 109 may operate the positioner 106 to move the sample 104 in the vertical direction 113 such that a predetermined strength of the interaction between the measuring tip 103 and the sample surface 115 is obtained.

The positioner 106 may further be operated to move the sample 104 in one or more horizontal directions 114 perpendicular to the vertical direction 113 to scan the sample surface 115 while maintaining a predetermined strength of interaction between the sample surface 115 and the measuring tip 103. Thereby, the position of the sample holder 115 in the vertical direction 113 may be measured to obtain spatially resolved measurements of features of the sample surface such as, for example, a height profile thereof. Techniques for measuring the position of the sample holder 115 in the vertical direction 113 may include, inter alia, determining a voltage applied to a piezoelectric actuator for moving the sample holder in the vertical direction 113, and interferometry.

The control electronics 109 of a scanning force microscope may have specific problems associated therewith. In control electronics 109 according to the state of the art, dynamic measurement of the current flowing through the electromechanical element 111 and complex impedance compensation can be performed by means of operational amplifier circuits for analog computations. The control electronics may, in particular, comprise one or more current voltage converters, voltage to voltage decouplers, adders, subtractors and Wien-bridge type phase shifters. Typically, a relatively large number of circuit elements and, in particular, operational amplifiers are needed for the analog computations, as well as for complex impedance compensation circuits.

The operation of control electronics 109 according to the state of the art comprising a relatively large number of operational amplifiers may be adversely affected by the presence of relatively large blind signals, as well as by a relatively high frequency of operation of the operational amplifiers. Nonlinearities and thermal drifting of amplitude and phase delay in operational amplifiers may deteriorate the performance of the control electronics. Moreover, voltage to voltage decouplers according to the state of the art may comprise optocouplers comprising a light emitting diode, having a non-linear current voltage characteristics, and may be subject to quantum noise. The nonlinear current-voltage characteristics as well as quantum noise may adversely affect the performance of the voltage-voltage decoupler and other circuit elements connected thereto.

Similar issues may occur in measuring instruments other than a scanning force microscope, for example in a coordinate measuring machine wherein a sample is scanned by means of an oscillating measuring tip. Furthermore, similar issues may occur in analog circuits which are employed for other purposes than the operation of a measuring instrument.

It is an object of the present invention to provide an interface circuit for a measuring instrument, a measuring instrument, and a method of operating a measuring instrument that may solve some or all of the above mentioned problems.

An interface circuit for a measuring instrument according to the present invention comprises the features defined in claim 1.

The transimpedance amplifier in the first electric circuit of the interface circuit may provide a relatively small or substantially zero impedance between the first amplifier input terminal and the second amplifier input terminal. Hence, the transformer may substantially be operated under a shortcut condition. Therefore, a current flowing through the at least one primary winding may induce an AC current in the secondary winding, the amplitude of which is substantially proportional to the AC component of the current flowing through the at least one secondary winding. However, a DC component of the current flowing through the primary winding does not induce a significant current in the secondary winding. Hence, voltage decoupling between circuit elements connected to the at least one primary winding and circuit elements connected to the at least one secondary winding can be obtained.

Moreover, due to the shortcut condition, electric potential differences between the terminals of the secondary winding and also electrical potential differences between portions of the primary winding, in particular an electric potential difference between terminals of the primary winding, can be relatively small or substantially zero. Thus, adverse effects of stray capacities of the at least one primary winding and the secondary winding which, in combination with the inductivities of the at least one primary winding and the secondary winding might form parasitic resonant circuits, can be avoided. Due to the small electric potential differences, an excitation of oscillations of such parasitic resonance circuits may be reduced or substantially avoided.

Due to the shortcut condition, a phase difference between the current flowing through the at least one primary winding and the current flowing through the at least one secondary winding may be substantially zero or substantially equal to n, depending on the relative arrangement of the at least one primary winding and the at least one secondary winding. Hence, the occurrence of blind currents and adverse effects of blind currents may be reduced or substantially avoided.

If a first AC current is applied between the first primary winding terminal and the second primary winding terminal and a second AC current is applied between the third primary winding terminal and the fourth primary winding terminal, the secondary winding is exposed both to the magnetic flux created by the first current and the magnetic flux created by the second current. Hence, the current induced in the secondary winding may be influenced both by the first current and the second current, and an amperage of the second current, as well as the output voltage of the transimpedance amplifier, can be representative of a superposition of the first AC current and the second AC current. Depending on the direction of flow of the first and the second AC current, a subtraction or an addition of the first and the second AC current can be obtained.

An interface circuit comprising a transformer with a first and a second primary winding and with a secondary winding and further comprising a transimpedance amplifier connected to the secondary winding is known from documents US 5 274 704 A and US 4 270 061 A.

If an AC voltage is applied between the first power source terminal and the second power source terminal of the interface circuit, a first electric current may flow through the electromechanical element of the sensor and the first primary winding of the transformer, and a second electric current may flow through the variable complex impedance and the second primary winding of the transformer. Amplitude and phase of the first and the second current depend on the impedance of the sensor, which may be complex, and on the variable complex impedance, respectively.

If the variable complex impedance were substantially equal to the impedance of the sensor, amplitude and phase of the first and the second current would be substantially equal. The connection of the sensor terminals and the variable complex impedance to the power source terminals and the first and second primary winding is such that the magnetic flux through the secondary winding caused by the first current and the magnetic flux through the secondary winding caused by the second current substantially compensate each other if amplitude and phase of the first and the second current are substantially equal. Hence, if the variable complex impedance and the impedance of the sensor were substantially equal, a relatively low or substantially zero output voltage of the interface circuit would be obtained.

If, however, the impedance of the sensor is different from the variable complex impedance, the magnetic fluxes created by the first and the second current in the secondary winding do not compensate each other, current flow through the secondary winding of the transformer is induced and an output voltage of the interface circuit which is representative of the difference between the variable complex impedance and the impedance of the sensor can be obtained.

In the operation of the measuring instrument, the variable complex impedance may be adjusted such that it is substantially equal to the impedance caused by the bulk capacity of the sensor and/or by undesirable elastic modes of oscillation of the body of the sensor. Thus, the output voltage of the interface circuit can be representative of a contribution of the desired elastic mode of oscillation of the body to the complex impedance of the sensor. Due to an interaction between the measuring tip and a sample surface, the contribution of the desired elastic mode of oscillation of the body to the impedance of the sensor is changed. This may have an influence on the output voltage of the interface circuit, and the amplitude as well as the phase of the output voltage may be representative of the strength of the interaction between the measuring tip and the sample.

In some embodiments, the first and second primary windings are provided in form of coils or portions of a single coil having a center tap.

In some embodiments, the variable complex impedance comprises a variable capacitor and a first variable resistor electrically connected in parallel. Since a variable capacitor and a variable resistor may have a relatively high stability, a high stability of the variable complex impedance can be obtained. This may help to reduce undesirable variations of the variable complex impedance during the measuring process.

In some embodiments, the interface circuit further comprises a second variable resistor electrically connected between the first sensor terminal and the second sensor terminal.

The second variable resistor can simplify the adjustment of the variable complex impedance in embodiments wherein the sensor has a small real part of the admittance. Since the second variable resistor is electrically connected in parallel to the sensor, the real part of the admittance of the parallel connection of the sensor and the second variable resistor can be approximately equal to the sum of the real part of the admittance of the sensor and the conductance of the second variable resistor. The real part of the admittance of the parallel connection of the first variable resistor and the variable capacitor can be approximately equal to the conductance of the first variable resistor. Therefore, the real part of the admittance of the sensor can be taken into account by adjustment of the first variable resistor and the second variable resistor. This can also be done in embodiments wherein the real part of the admittance of the sensor is so small that resistors or potentiometers with a correspondingly high resistance are not readily available in the market. Moreover, the first variable resistor and the second variable resistor can also be adjusted to compensate a negative real part of the admittance of the sensor, corresponding to a generation of electric energy in the sensor.

A measuring instrument according to the present invention comprises the features defined in claim 5.

If an AC voltage is applied between the first phase shifter input terminal and the second phase shifter input terminal of the phase shifter of the measuring instrument, a first current may flow through the first complex impedance and a second current may flow through the second complex impedance. The connection of the first and the second complex impedance to the first and the second primary winding, respectively, is such that the magnetic flux in the secondary winding caused by the first current and the magnetic flux in the secondary winding caused by the second current substantially compensate each other if amplitude and phase of the first and the second current are substantially equal, which may be the case if the first and the second complex impedance are substantially equal. If the first and the second complex impedance are different, the magnetic fluxes need not compensate each other any more, and current flow through the secondary winding of the transformer as well as a moderate output voltage of the transimpedance amplifier may be obtained. A phase difference between the AC voltage applied to the first and the second phase shifter input terminal and the output voltage of the transimpedance amplifier may depend on a difference between the first and the second complex impedance. Compared to phase shifter according to the state of the art such as, for example, a Wien bridge type phase shifter, the phase shifter according to the present invention may comprise a relatively small number of components. These components may be selected to provide a desired precision of the phase shifter. Moreover, the transimpedance amplifier may, in some embodiments, comprise a single operational amplifier, and a phase delay of the operational amplifier may have a relatively small influence on the phase shift provided by the phase shifter.

As described above, the output voltage of the interface circuit of the measuring instrument may be representative of a contribution of a desired elastic mode of oscillation of the body of the sensor to the impedance of the sensor. An output voltage of the phase shifter may have a predetermined phase difference to the output voltage of the interface circuit. By superimposing the output voltage of the phase shifter and the AC voltage provided by the oscillator, feedback of the sensor output to the sensor input may be obtained. The feedback may enhance or suppress the elastic oscillation of the body of the sensor in the desired elastic mode of oscillation, depending on the phase shift provided by the phase shifter. This may help to control a Q-factor of the desired elastic mode of oscillation of the body of the sensor. Thus, the desired elastic mode of oscillation of the body of the sensor may be enhanced, undesirable elastic modes of oscillation of the body can be less efficiently enhanced and/or undesirable elastic modes of oscillation of the body can be suppressed. Moreover, the strength of the elastic interaction between the measuring tip of the sensor and the sample surface can be inferred from the output voltage of the interface circuit, as detailed above.

In some embodiments, each of the first complex impedance of the phase shifter and the second complex impedance of the phase shifter comprises a capacitor and a resistor connected in parallel. Capacitors and resistors may have a relatively high stability. Thus, a relatively high stability of the phase shift provided by the phase shifter can be obtained.

In some embodiments, at least on of the first complex impedance of the phase shifter and the second complex impedance of the phase shifter is a variable complex impedance. Thus, the phase shift provided by the phase shifter may be adjusted.

A method of operating a measuring instrument according to the present invention comprises the features defined in claim 8.

By adjusting the variable complex impedance of the interface circuit, the variable complex impedance may be equalized, at least approximately, to the contribution of the bulk capacity and/or undesirable elastic modes of oscillation to the impedance of the sensor. When the surface of the sample is scanned by the measuring tip, the complex impedance of the sensor may change due to the interaction between the measuring tip and the surface of the sample, leading to an alteration of the output voltage of the interface circuit. A stronger interaction may be obtained if the distance between the measuring tip and the sample surface is reduced. If the distance between the measuring tip and the sample surface is increased, the strength of the interaction may decrease. By controlling the distance between the measuring tip and the sample holder on the basis of the output voltage of the interface circuit, a desired distance or strength of interaction, respectively, between the measuring tip and the sample surface may be maintained. Hence, the distance between the measuring tip and the sample holder may be representative of properties of the sample surface such as a height profile thereof.

In some embodiments, the method of operating a measuring instrument further comprises providing a phase shifter having the features defined in claim 9. The output voltage of the interface circuit is applied between the first phase shifter input terminal and the second phase shifter input terminal of the phase shifter. The variable complex impedance of the phase shifter is adjusted to obtain a predetermined phase difference between the output voltage of the interface circuit and the output voltage of the phase shifter. The output voltage of the phase shifter and an AC signal having a predetermined frequency and amplitude are superimposed to form a superposition voltage. The superposition voltage is applied between the first power source terminal and the second power source terminal as the AC voltage. Thus, a Q-factor of a desired elastic mode of oscillation of the body of the sensor which is excited by applying the second AC voltage can be controlled.

In the following, embodiments of the present invention will be described with respect to the enclosed figures, wherein:

Fig. 1 shows a schematic cross-sectional view of a scanning force microscope according to the state of the art;

Fig. 2 shows a schematic circuit diagram of an electric circuit;

Fig. 3 shows a schematic circuit diagram of an other electric circuit;

Fig. 4a shows a schematic circuit diagram of an interface circuit for a scanning force microscope according to an embodiment of the present invention;

Fig. 4b shows a schematic circuit diagram of an interface circuit for a scanning force microscope according to another embodiment of the present invention;

Fig. 5 shows a schematic circuit diagram of an equivalent circuit of a sensor for a scanning force microscope;

Fig. 6 shows a schematic circuit diagram of a phase shifter according to an embodiment of the present invention;

Fig. 7 shows a schematic circuit diagram of a scanning force microscope according to an embodiment of the present invention; and

Fig. 8 shows a schematic circuit diagram of an AC voltage to voltage decoupler.

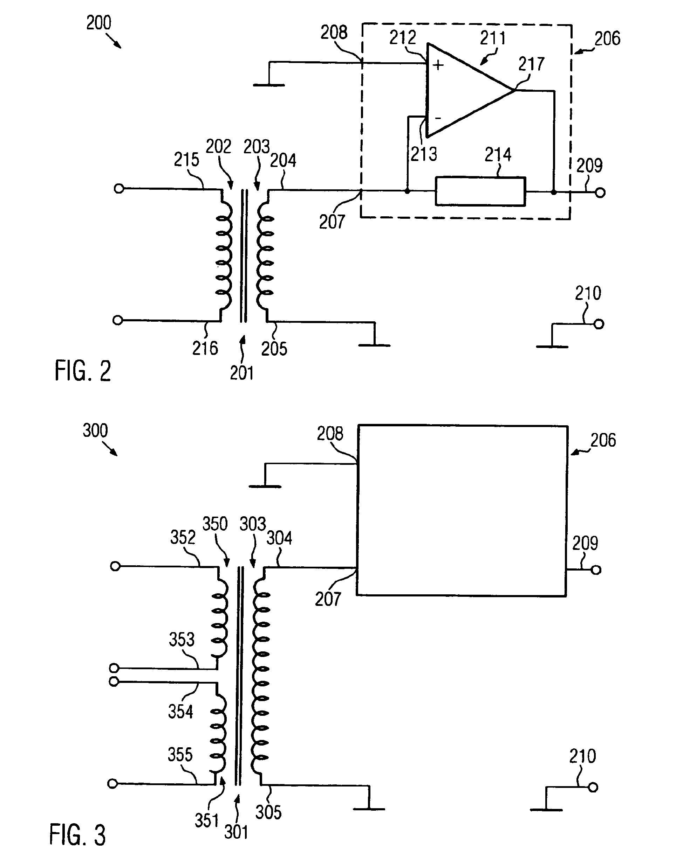

Fig. 2 shows a schematic circuit diagram of an electric circuit 200.

The circuit 200 comprises a transformer 201. The transformer 201 comprises a primary winding 202 and a secondary winding 203. The primary winding 202 comprises a first primary winding terminal 215 and a second primary winding terminal 216 adapted for providing an electrical connection between the primary winding 201 and other circuit elements. Similarly, the secondary winding 203 comprises a first secondary winding terminal 203 and a second secondary winding terminal 205 for providing an electrical connection between the secondary winding 203 and other circuit elements. The primary winding 202 and the secondary winding 203 are inductively coupled to each other. Thus, an electric current flowing through the primary winding 202 creates a magnetic flux in the secondary winding 203 such that an alteration of the current flowing through the primary winding 202 may induce an electric current in the secondary winding 203.

In one embodiment, the transformer 201 may be a high frequency transformer adapted for operation at typical frequencies used for the excitation of elastic oscillations in sensors of scanning force microscopes. For example, the transformer 201 may be adapted for operation at frequencies in a range from about 10 kHz to about 10 MHz. In other embodiments, the transformer 201 can be adapted for operation in a different frequency range.

The electric circuit 200 further comprises a transimpedance amplifier 206. The transimpedance amplifier 206 comprises a first amplifier input terminal 207, a second amplifier input terminal 208 and an output terminal 209.

The first amplifier input terminal 207 is electrically connected to the first secondary winding terminal 204 and the second amplifier input terminal 208 is electrically connected to the second secondary winding terminal 205. In the embodiment shown in Fig. 2, electrical connection between the second secondary winding terminal 205 and the second amplifier input terminal 208 is provided by connecting both the second secondary winding terminal 205 and the second amplifier input terminal 208 to ground, and electrical connection between the first secondary winding terminal 204 and the first amplifier input terminal 207 is provided by means of an electrically conductive line. In other embodiments, electrically conductive lines may be used both for connecting the first secondary winding terminal 204 to the first amplifier input terminal 208 and for connecting the second secondary winding terminal 205 to the second amplifier input terminal 208.

The transimpedance amplifier 206 is adapted to output a voltage representative of a current flowing through the secondary winding 203. In the embodiment shown in Fig. 2, the output voltage 209 is provided between the output terminal 209 of the transimpedance amplifier 206 and a grounded terminal 210.

In some embodiments, the transimpedance amplifier 206 may comprise an operational amplifier 211 and an ohmic resistor 214. The operational amplifier 211 comprises an inverting input 213, a non-inverting input 212 and an output 217. Additionally, the operational amplifier 211 may comprise a positive and a negative power supply terminal (not shown). The ohmic resistor 214 is connected between the inverting input 213 and the output 217 of the operational amplifier 211.

In some embodiments, the inverting input 213 may form the first amplifier input terminal 207 and the non-inverting input 212 may form the second amplifier input terminal. In other embodiments, the first amplifier input terminal 207 and/or the second amplifier input terminal 208 may be provided in form of electrically conductive lines electrically connected to the inverting input 213 and the non-inverting input 212, respectively. The output terminal 209 of the transimpedance amplifier 206 may be formed by the output 217 of the operational amplifier 211 or can be electrically connected thereto.

The ohmic resistor 214 provides a feedback between the output 217 and the inverting input 213 of the operational amplifier 211. Thus, when the operational amplifier 211 is operated, the output voltage of the operational amplifier is adjusted such that the electric potential difference between the inverting input 213 and the non-inverting input 212 is approximately zero. Since the inverting input 213 is electrically connected to the first secondary winding terminal 204 and the non-inverting input 212 is electrically connected to the second secondary winding terminal 212, the electric potential difference between the first secondary winding terminal 202 and the second secondary winding terminal may become approximately zero. Thus, a shortcut condition can be established between the first secondary winding terminal 204 and the second secondary winding terminal 205 such that the transformer 201 is operated substantially under a shortcut condition.

The input impedance of the inverting input 213 and the non-inverting input 212 may be large compared to the resistance of the ohmic resistor 214 such that a current flowing through the ohmic resistor 214 is substantially identical to a current flowing through the secondary winding 203. Hence, the output voltage of the transimpedance amplifier 206 may be substantially equal to a product of the resistivity of the ohmic resistor 214 and the current flowing through the secondary winding 203 of the transformer 201.

The present invention is not restricted to embodiments wherein the transimpedance amplifier 206 has a configuration as described above. In other embodiments, a transimpedance amplifier having a different configuration may be used, for example a single transistor amplifier stage that is internally AC-coupled by capacitors to the terminals 207 and 209, so that it can be specially adapted for very low cost applications or, when using two cascoded transistors, for very high bandwidth, since cascoding greatly reduces the influence of the Miller-capacity between input and output of the stage.

If an electric current is applied between the first primary winding terminal 215 and the second primary winding terminal 216, a magnetic flux may be formed in the secondary winding 203. If the electric current is an AC current or comprises an AC component, the magnetic flux in the secondary winding may change with time such that an electric current is induced in the secondary winding 203, and an output voltage of the transimpedance amplifier 206 representative of the current flowing through the secondary winding 203 and, hence, representative of the AC component of the electric current flowing through the primary winding 202 is obtained.

In some embodiments of the present invention, the number of turns of the primary winding 202 may be equal to the number of turns of the secondary winding 203, and the transformer 201 may be adapted to provide a relatively high coupling efficiency between the primary winding 202 and the secondary winding 203. Thus, the amplitude of the electric current flowing through the secondary coil 203 may be approximately equal to the amplitude of the AC component of the current flowing through the primary coil 202, if the frequency or frequencies of the AC component of the current flowing through the primary coil 202 is/are within the frequency range of operation of the transimpedance amplifier. In embodiments wherein the transimpedance amplifier 206 comprises an operational amplifier 211 and an ohmic resistor 214 which are connected as described above, the amplitude of the output voltage of the transimpedance amplifier may thus be approximately equal to the product of the amplitude of the current flowing through the primary winding 202 and the resistivity of the resistor 214.

In other embodiments, the number of turns of the primary winding 202 and the number of turns of the secondary winding 203 may be different from each other. In case of a relatively high inductive coupling efficiency between the primary winding 202 and the secondary winding 203, a ratio between the amplitudes of the current flowing through the secondary winding and the current flowing through the primary winding 202 may then be approximately equal to the ratio between the number of turns of the primary winding 202 and the number of turns of the secondary winding 202. This may allow an adaptation of the electric current flowing through the secondary coil 203 to the range of operation of the operational amplifier.

If the electric current flowing through the primary winding 202 comprises a DC component or is a DC current, the magnetic flux in the secondary winding 203 created by the DC current or DC component is substantially constant. As persons skilled in the art know, a substantially constant magnetic flux can substantially not induce any electric current in the secondary winding 203. Hence, a DC current flowing through the primary winding 202 may have a relatively low influence or substantially no influence on the output voltage of the transimpedance amplifier 206. Thus, the electric circuit 200 allows to separate an AC component of the electric current flowing through the primary winding 202 from a DC component thereof.

Moreover, the primary winding 202 and the secondary winding 203 may be only inductively coupled to each other, and there need not be a galvanic connection between the primary winding 202 and the secondary winding 203. Furthermore, there need not be a galvanic connection between circuit elements connected to the primary winding 202 and circuit elements connected to the secondary winding 203.

Therefore, circuit elements connected to the primary winding 202 may be connected to a different ground potential than circuit elements connected to the secondary winding 203.

In one embodiment of the present invention, the electric circuit 200 may be used for AC current voltage conversion. An AC current voltage converter circuit according to the present invention may comprise the electric circuit 200, means for applying an input current of the AC voltage to voltage converter to the primary winding 202 and means for providing the output voltage of the transimpedance amplifier 206 as an output voltage of the transimpedance amplifier. The means for applying the input current of the AC voltage to voltage converter to the primary winding may be provided in form of the first primary winding input terminal 215 and the second primary winding input terminal 216, or in form of electrically conductive lines connected thereto. The means for providing the output voltage of the transimpedance amplifier 206 as an output voltage of the AC current voltage converter may be provided in form of the output terminal 209 and the grounded terminal 210, or in form of electrically conductive lines connected thereto.

Further applications of the electric circuit 200 will be described below.

The present invention is not restricted to embodiments wherein the transformer 201 comprises a single primary winding, as shown in Fig. 2. In other embodiments, the transformer of the electric circuit according to the present invention may comprise two or more primary windings, as will be described in the following with reference to Fig. 3.

Fig. 3 shows a schematic circuit diagram of an electric circuit 300. The electric circuit 300 comprises a transimpedance amplifier 206. The transimpedance amplifier 206 comprises a first amplifier input terminal 207, a second amplifier input terminal 208 and an output terminal 209. Features of the transimpedance amplifier 206 may correspond to those described above with reference to Fig. 2. For convenience, in Figs. 2 and 3, like reference numerals have been used to denote like components.

The electric circuit 300 further comprises a transformer 301. The transformer 301 comprises a secondary winding 303 having a first secondary winding terminal 304 and a second secondary winding terminal 305. The first secondary winding terminal 304 is electrically connected to the first amplifier input terminal 207 and the second secondary winding terminal 305 is electrically connected to the second amplifier input terminal 208. Features of the electric connection between the secondary winding terminals 304, 305 and the amplifier input terminals 207, 208 may correspond to those of the connection of the secondary winding terminals 204, 204 to the amplifier input terminals 207, 208 in the electric circuit 200 described above with reference to Fig. 2.

The transformer 301 additionally comprises a first primary winding 350 and a second primary winding 351. The first primary winding 350 comprises a first primary winding terminal 352 and a second primary winding terminal 353 and the second primary winding 351 comprises a third primary winding terminal 354 and a fourth primary winding terminal.

A first electric current may be applied between the first primary winding terminal 352 and the second primary winding terminal 353 to flow the first electric current through the first primary winding 350. A second electric current may be applied between the third primary winding terminal 354 and the fourth primary winding terminal to flow the second electric current through the second primary winding 351. The first primary winding 350 and the second primary winding 351 may be arranged such that both the first and the second electric current create a magnetic flux in the secondary winding 303.

The arrangement of the first and second primary windings 350, 351 and the secondary winding 351 may be such that the magnetic flux in the secondary winding is in the same direction if the current direction of the first electric current is from the first primary winding terminal 352 to the second primary winding terminal 353 and the current direction of the second electric current is from the third primary winding terminal 354 to the fourth primary winding terminal 355. As persons skilled in the art know, the direction of the magnetic flux in the secondary winding 303 created by electric currents through the first 350 and the second 351 primary winding may be determined by the relative arrangement of the first primary winding 350, the second primary winding 351 and the secondary winding 303, as well as by the winding direction of the primary windings 350, 351 and the secondary winding 303.

In one embodiment, the first primary winding 351 and the second primary winding 351 may be provided in form of coils having the same winding direction and, optionally, enclosing a common core formed of ferroelectric material. In this embodiment, the secondary winding 303 may also be provided in form of a coil enclosing the core.

If the first electric current and/or the second electric current change with time, an electric current flowing through the secondary winding 303 may be induced. The amperage of the current flowing through the secondary winding 303 may depend on the AC component of the first electric current and the AC component of the second electric current. In the following discussion, $I_1$ shall denote the amperage of the first electric current and $I_2$ shall denote the amperage of the second electric current. $I_1$ shall be positive, if the current direction of the first electric current is from the first primary winding terminal 352 to the second primary winding terminal 353, and negative, if the current direction of the first electric current is from the second primary winding terminal 353 to the first primary winding terminal 352. Similarly, $I_2$ shall be positive if the current direction of the second electric current is from the third primary winding terminal 354 to the fourth primary winding terminal, and negative if the current direction of the second electric current is from the fourth primary winding terminal 355 to the third primary winding terminal.

In embodiments wherein a relatively high inductive coupling efficiency between the primary windings 350, 351 and the secondary winding 303 is provided, the fraction of the magnetic flux $\Phi_1$ in the secondary winding 303 created by the first and the second electric current may be approximately

$$\Phi_1(t) = N_{11} I_1(t) + N_{12} I_2(t) \qquad (1)$$

wherein $N_{11}$ is the number of turns of the first primary winding 350, $N_{12}$ is the number of turns of the second primary winding 351 and t denotes time.

If the magnetic flux $\Phi_1$ changes with time, an electric current may be induced in the secondary winding 303, the amperage of which shall be denoted by $I_3$. The electric current flowing through the secondary winding 303 creates a magnetic flux $\Phi_2$ in the secondary winding, which is related to the amperage $I_3$ as follows, wherein $N_2$ is the number of turns of the secondary winding:

$$\Phi_2(t) = N_2 I_3(t) \qquad (2)$$

As detailed above, the transimpedance amplifier 206 provides a shortcut condition between the first secondary winding terminal 303 and the second secondary winding terminal 305 such that the electric potential difference between the first 303 and the second 305 secondary winding terminal is approximately zero. According to the law of induction, this implies

$$\frac{d\Phi_1(t)}{dt} = -\frac{d\Phi_2(t)}{dt}, \tag{3}$$

because an electric potential difference between the secondary winding terminals 303, 305 would be obtained if the total magnetic flux in the secondary winding 303 would vary with time.

In some embodiments of the present invention, the number of turns of the first primary winding 350, the number of turns of the second primary winding 351 and the number of turns of the secondary winding 303 may be equal, such that $N_{11} = N_{12} = N_2$. In such embodiments, one obtains from equations (1), (2) and (3):

$$I_3(t) = -\left(I_1(t) + I_2(t)\right) + const. \tag{4}$$

By Fourier transformation of equation (4), we obtain that

$$I_3(\omega) = -\left(I_1(\omega) + I_2(\omega)\right) \tag{5}$$

for all angular frequencies $\omega \neq 0$. Hence, the AC component of the electric current flowing through the secondary winding 303 and, correspondingly, the output voltage of the transimpedance amplifier 206 obtained between the output terminal 209 of the transimpedance amplifier 206 and a grounded terminal 210 are representative of a sum of the AC components of the first and the second electric current. Since a DC current may not be obtained by electrical induction in a transformer operating under a shortcut condition, the DC component of the electric current flowing through the secondary winding 304 and, correspondingly, the DC component of the output voltage of the transimpedance amplifier 206 is approximately zero.

The present invention is not limited to embodiments wherein the number of turns of the primary windings 350, 351 and the secondary winding 303 is equal. In other embodiments, the number of turns of at least two of the first primary winding 350, the second primary winding 351 and the secondary winding 303 may be different. In such embodiments, the output voltage of the transimpedance amplifier 206 may be representative of a weighted sum of the AC components of the first and the second electric current, wherein the amperages of the first and the second electric current are weighted with the ratio between the number of turns of the respective primary winding 350, 351 and the number of turns of the secondary winding 303.

In some embodiments of the present invention, the first primary winding 350 and the second primary winding 351 may be provided in form of portions of a single coil having a center tap. In such embodiments, the first primary winding terminal 352 can be provided in form of an electrical connection to a first end of the coil and the fourth primary winding terminal 355 may be provided in form or an electrical connection to a second end of the coil. A first portion of the coil between the center tap and the first end of the coil forms the first primary winding 350 and a second portion of the coil between the center tap and the second end of the coil forms the second primary winding 351. The second primary winding terminal 353 is provided in form of an electrical connection between the first portion of the coil and the center tap. The third primary winding terminal 354 is provided in form of an electric connection between the second portion of the coil and the center tap. In such embodiments, the second primary winding terminal 353 and the third primary winding terminal 354 are electrically connected to each other. In some embodiments, the electrical connections between the first and the second portions of the coil and the center tap that form the second primary winding terminal 353 and the third primary winding terminal 354 may, at least partially, provided by one or more common components. In one such embodiment, both electrical connections can be provided by a soldering joint between a wire of the coil and the center tap.

Further features of the transformer 301 may be similar to those of the transformer 201 described above with reference to Fig. 2.

The electric circuit 300 may be used in an AC superposition circuit for creating a voltage representative of a superposition of a first AC current and a second AC current. In addition to the electric circuit 300, the AC superposition circuit may comprise means for applying the first AC current to the first primary winding 350, means for applying the second AC current to the second primary winding and means for providing the output voltage of the transimpedance amplifier 206 as an output voltage of the AC superposition circuit. The means for applying the first AC current may be formed by the first 352 and second 353 primary winding terminals and/or by electrically conducive lines connected thereto. The means for applying the second AC current may be formed by the third 354 and fourth 355 primary winding terminals and/or by electrically conductive lines connected thereto. The means for providing the output voltage of the transimpedance amplifier 206 as the output voltage of the AC superposition circuit may be formed by the terminals 209, 210 and/or by electrically conductive lines connected thereto.

As detailed above, the electric current flowing through the secondary winding 303 of the transformer 301 and the output voltage of the transimpedance amplifier 206 may be representative of a sum of the first electric current flowing through the first primary winding 350 and the second electric current flowing through the second primary winding 351, wherein a positive amperage of the first electric current has been defined as corresponding to current flow from the first primary winding terminal 352 to the second primary winding terminal 353, and a positive amperage of the second electric current flowing through the second primary winding 351 was defined as corresponding to current flow from the third primary winding terminal 354 to the fourth primary winding terminal 355. In the AC superposition circuit, the first AC current may be applied to the first primary winding terminal 352 and the second primary winding terminal in such a manner that the first electric current, as defined above, is equal to the first AC current or, by exchanging the connections of a power source providing the first AC current to the first 352 and the second 353 primary winding terminal, is inverse to the first AC current. Similarly, depending on the connection between a power source providing the second AC current and the third 354 and fourth 355 primary winding terminals, the second electric current, as defined above, may be equal to or inverse to the second AC current. Hence, the output voltage of the AC superposition circuit may be representative of a sum or a difference of the first AC current and the second AC current.

The AC superposition circuit described above can also be used for superposition of a first and a second AC voltage. For this purpose, a first and a second ohmic resistor having a substantially equal resistivity can be connected in series with the first 350 and the second 351 primary winding. The first AC voltage may be applied to the series connection of the first resistor and the first primary winding 350, and the second AC voltage may be applied to the series connection of the second primary winding 351 and the second resistor.

An AC subtraction circuit according to an embodiment of the present invention may comprise an electric circuit 300 as described above, a first subtraction circuit input terminal electrically connected to the first primary winding terminal 352, a second subtraction circuit input terminal electrically connected to the second primary winding terminal 353 and the third primary winding terminal 354, and a third subtraction circuit input terminal electrically connected to the fourth primary winding terminal 355. The first, second and third subtraction circuit input terminals can be configured for application of the first AC current between the second subtraction circuit input terminal and the first subtraction circuit input terminal, and for application of the second AC current between the second subtraction circuit input terminal and the third subtraction circuit input terminal.

Due to the connection between the subtraction circuit input terminals and the primary winding terminals 352, 353, 354, the first electric current flowing through the first primary winding 350 is inverse to the first AC current, and the second electric current flowing through the second primary winding 351 is substantially equal to the second AC current. Hence, according to equations (4) and (5), the output voltage of the AC subtraction circuit can be representative of a difference between the first and the second AC current.

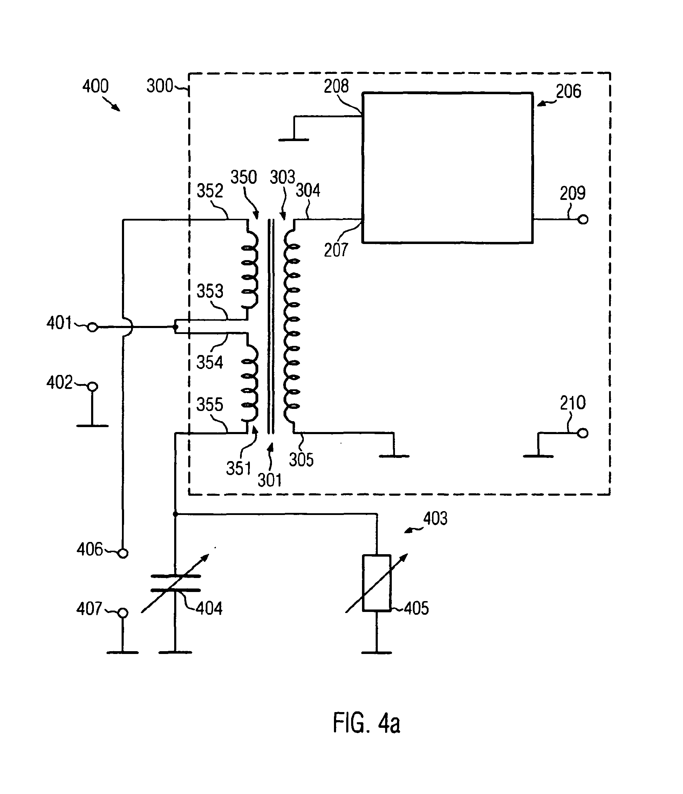

Fig. 4a shows a schematic circuit diagram of an interface circuit 400 for a scanning microscope wherein the electric circuit 300 described above is used.

In addition to the electric circuit 300, the interface circuit 400 comprises a first power source terminal 401 and a second power source terminal 402. As will be explained in more detail below, a power source configured to provide an AC voltage having a frequency approximately equal to the frequency of a desired elastic mode of oscillation of the sensor of a scanning force microscope can be electrically connected to the first power source terminal 401 and the second power source terminal 402. The interface circuit 400 may be used for supplying the AC voltage provided by the power source to the sensor as an operating voltage, and for sensing a response of the sensor to the AC voltage.

The first power source terminal 401 is electrically connected both to the second primary winding terminal 353 and the third primary winding terminal 354. Hence, in the interface circuit 400, the second primary winding terminal 353 and the third primary winding terminal 354 are electrically connected to each other. Thus, in some embodiments, the first primary winding 350 and the second primary winding 351 can be provided in form of a single coil having a center tap, wherein the first power source terminal 401 is electrically connected to the center tap. In other embodiments, the first primary winding 350 and the second primary winding 351 may be provided in form of two separate coils.

The interface circuit 400 further comprises a first sensor terminal 406 and a second sensor terminal 407. In the operation of the interface circuit 400, an electromechanical element of the sensor of a scanning force microscope which may, for example, be a piezoelectric actuator/sensor element as described above with reference to Fig. 1, can be electrically connected between the first sensor terminal 406 and the second sensor terminal 407.

The first sensor terminal 406 is electrically connected to the first primary winding terminal 352 and the second sensor terminal 407 is electrically connected to the second power source terminal 402. In some embodiments, electrical connection between the second power source terminal 402 and the second sensor terminal 407 can be provided by connecting both the second power source terminal 402 and the second sensor terminal 407 to ground, as shown in Fig. 4a. In other embodiments, an electrically conductive line connecting the second power source terminal 402 to the second sensor terminal 407 may be formed.

The interface circuit 400 further comprises a variable complex impedance 403. In some embodiments, the variable complex impedance 403 may comprise a variable capacitor 404 and a variable ohmic resistor 405 which are electrically connected in parallel, as shown in Fig. 4a. The variable complex impedance 403 is electrically connected between the second power source terminal 402 and the fourth primary winding terminal 355, wherein, in some embodiments, the electrical connection between the second power source terminal 402 and the variable complex impedance 403 can be provided by connecting both the second power source terminal 402 and one of the terminals of each of the variable capacitor 404 and the variable ohmic resistor 405 to ground.

The variable capacitor 404 can be a variable capacitor of a type known to persons skilled in the art, for example a mechanical variable capacitor such as a rotary capacitor, or an electronically controlled variable capacitor such as a varactor diode. The variable ohmic resistor 405 may, in some embodiments, comprise a potentiometer or a rheostat. In other embodiments, the variable ohmic resistor 405 may comprise an electronically controllable element providing a variable ohmic resistance, for example a bipolar transistor or a field effect transistor.

A current that flows through the variable capacitor 404 and the variable ohmic resistor 405 if an AC voltage is applied to the respective circuit element may be characterized by the complex impedance of the variable capacitor 404 and the variable ohmic resistor 405. The impedance of the variable ohmic resistor 405 may be substantially real and equal to R, wherein R denotes the resistivity of the variable ohmic resistor 405. The impedance of the variable capacitor 404 may be substantially imaginary and equal to $-j/\omega C$, wherein j is the imaginary unit, $\omega$ is the angular frequency of the AC voltage and C is the capacitance of the variable capacitor 404. Since the variable ohmic resistor 405 and the variable capacitor 404 are electrically connected in parallel, the variable complex impedance 403 may be influenced both by the resistivity R and the capacity C. If R is small compared to $1/\omega C$, the impedance of the variable complex impedance 403 is substantially real and approximately equal to R. If R is large compared to $1/\omega C$, the impedance of the variable complex impedance is substantially imaginary and approximately equal to $-j/\omega C$. If R and $1/\omega C$ are on the same order of magnitude, the impedance of the variable complex impedance may have non-neglectable real and imaginary parts. By varying the resistivity of the variable ohmic resistor 405 and the capacity of the variable capacitor 405, both the real and the imaginary part of the impedance of the variable complex impedance 403 can be controlled.

The sensor terminals 406, 407 may be connected to the sensor of a scanning force microscope. The sensor may comprise a body having a measuring tip connected thereto and an electromechanical element adapted to excite an elastic oscillation of the body. In some embodiments, the sensor may have a configuration similar to the sensor 110 described above with reference to Fig. 1. In other embodiments, the sensor may have a configuration corresponding to that disclosed in EP 2 120 037 A1 published on 18.11.2009 or a configuration corresponding to that disclosed in EP 2 120 036 A1 published on 18.11.2009.

If an AC voltage is applied to the electromechanical element of the sensor, an electric current may flow through the electromechanical element. The current flowing through the electromechanical element may be influenced by the capacity of the electromechanical element itself, which will be denoted as "bulk capacity" in the following. Moreover, upon application of the AC voltage to the electromechanical element, the electromechanical element may exhibit a periodically alternating force to portions of the body adjacent the electromechanical element, or elastic and inertial forces may occur in the electromechanical element itself, which may excite elastic oscillations of the body of the sensor. Depending on the frequency of the AC voltage, one or more elastic modes of oscillation of the body may be excited. The elastic oscillation of the body, in turn, may cause a counterforce exhibited by portions of the body adjacent the electromechanical element on the electromechanical element, and/or a counterforce caused by elastic and/or inertial forces occurring in the electromechanical element itself. The counterforce may cause an electric response of the electromechanical element having an influence on the current flowing through the electromechanical element. Hence, the current flowing through the electromechanical element may be influenced both by the bulk capacity and by the elastic modes of oscillation of the body of the sensor.

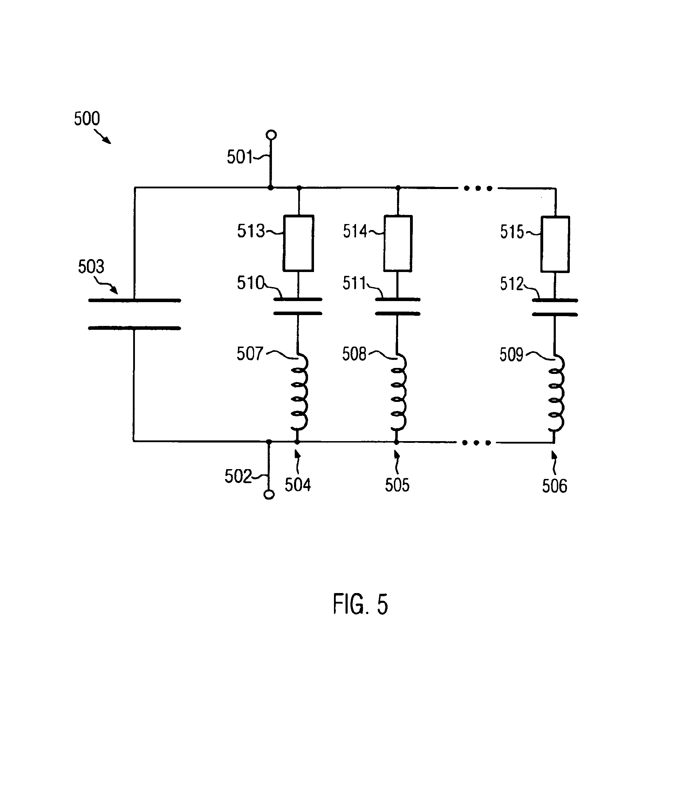

Fig. 5 shows an equivalent circuit diagram 500 of the sensor of the scanning force microscope which may be helpful for understanding the current flowing through the electromechanical element of the sensor if an AC voltage is applied to the electromechanical element. A first terminal 501 and a second terminal 502 represent terminals of the electromechanical element of the sensor which may be connected to the sensor terminals 406, 407 of the interface circuit 400. A capacitor 503 represents the bulk capacity of the electromechanical element. Resonant circuits 504, 505, 506 represent elastic modes of oscillation of the body of the sensor. The resonant circuit 504 comprises an inductivity 507, a capacity 510 and a resistance 513. Similarly, the resonant circuits 505, 506 comprise inductivities 508, 509, capacities 511, 512 and resistivities 514, 515. The inductivities 507, 508, 509, the capacities 510, 511, 512 and the resistivities 513, 514, 515 define a frequency of oscillation and a damping of each of the resonant circuits 504, 505, 506, wherein the frequency of oscillation and the damping of each of the resonant circuits 504, 505, 506 may correspond to the frequency of oscillation and the damping of one elastic mode of oscillation of the body of the sensor.

Although, in embodiments of the present invention, the sensor of a scanning force microscope is not comprised of the circuit elements constituting the equivalent circuit 500, the current flowing through the electromechanical element of the sensor in response to an AC voltage may be approximately equal to the current that would flow through the equivalent circuit 500 if the AC voltage were applied between the terminals 501, 502. Therefore, the equivalent circuit 500 may be helpful for understanding the current response of the electromechanical element of the sensor to an AC voltage applied thereto.

The body of the sensor need not comprise three elastic modes of oscillation as indicated by the equivalent diagram 500 shown in Fig. 5. In other embodiments, the body may have more than three or less than three elastic modes of oscillation, which may be taken into account by correspondingly adapting the number of resonant circuits in the equivalent diagram 500.

In the equivalent circuit 500, the capacity 503 and the resonant circuits 504, 505, 506 are electrically connected in parallel. Hence, the admittance of the equivalent circuit 500, which is the inverse of the impedance of the equivalent circuit 500, is substantially equal to a sum of the admittances of the capacity 503 and the resonant circuits 504, 505, 506. Each of the admittances of the capacity 503 and the resonant circuits 504, 505, 506 can be complex, and may depend on the frequency of the AC voltage applied to the equivalent circuit 500. Hence, the admittance $Y(\omega)$ of the equivalent circuit 500 at an angular frequency $\omega$, being approximately equal to the admittance of the electromechanical element of the sensor at the angular frequency $\omega$ is given substantially by

$$Y_{sensor}(\omega) = j\omega C_{bulk} + \sum_{l=1}^{N}(G_l(\omega) + jB_l(\omega)) \qquad (6)$$

wherein $C_{bulk}$ denotes the bulk capacity of the electromechanical element, $G_l(\omega)$ denotes the real part of the admittance of an l-th one of the resonant circuits 504, 505, 506, $B_l(\omega)$ denotes the imaginary part of an l-th one of the resonant circuits 504, 505, 506, and N denotes the total number of resonant circuits 504, 505, 506 in the circuit diagram 500.

If an AC voltage is applied between the power source terminals 401, 402 of the interface circuit 400, the AC voltage is substantially applied also between the sensor terminals 406, 407 connected to the electromechanical element of the sensor, and an electric current may flow through the electromechanical element of the sensor as well as through the first primary winding 350 of the transformer 350.

In the interface circuit 400, a positive electric current flowing from the first power source terminal 401 to the second power source terminal 402 and from the first sensor terminal 406 to the second sensor terminal 407 via the electromechanical element of the sensor connected to the sensor terminals 406, 407 is flowing through the first primary winding 350 of the transformer 301 in the direction from the second primary winding 353 to the first primary winding 352. Hence, the sign of the first electrical current $I_1$ flowing through the first primary winding 350, which was defined as being positive if the current direction is from the first primary winding terminal 352 to the second primary winding terminal 353, is opposite to the sign of the electrical current flowing from the first power source terminal 401 to the second power source terminal 402 via the electromechanical element of the sensor.

Thus, we obtain

$$I_1(\omega) = -Y_{sensor}(\omega)U(\omega) \qquad (7)$$

wherein $U(\omega)$ denotes the AC voltage of frequency $\omega$ applied between the power source terminals 401, 402.

If an electric voltage is applied between the power source terminals 401, 402, an electric current may also flow from the first power source terminal 401 to the second power source terminal 402 via the second primary winding 351 and the variable complex impedance 403. If this current is positive, the direction of current flow in the second primary winding 351 is from the third primary winding terminal 354 to the fourth primary winding terminal 355. Therefore, the sign of the second electric current $I_2$ flowing through the second primary winding terminal 303, which was defined as being positive if the current direction is from the third primary winding terminal 354 to the fourth primary winding terminal, is equal to the sign of the electric current flowing through the variable complex impedance in the direction from the first power source terminal to the second power source terminal. Thus, we obtain

$$I_2(\omega) = Y_{comp}(\omega)U(\omega) \qquad (8)$$

wherein $Y_{comp}(\omega)$ denotes the admittance of the variable complex impedance 403 at frequency $\omega$, being the reciprocal value of the impedance of the variable complex impedance 403 at frequency $\omega$.

Inserting equations (7) and (8) into equation (5), we obtain

$$I_3(\omega) = U(\omega)\big(Y_{sensor}(\omega) - Y_{comp}(\omega)\big) \qquad (9)$$

Hence, if an AC voltage having an angular frequency $\omega$ is applied between the first power source terminal 401 and the second power source terminal 402, the electric current flowing through the secondary winding 303 and, correspondingly, the output voltage of the transimpedance amplifier 206, are representative of a difference between the admittance of the electromechanical element of the sensor connected between the sensor terminals 406, 407 and the admittance of the variable complex impedance 403.

As detailed above, the resonance circuits 504, 505, 506 in the equivalent circuit diagram 500 are representative of elastic modes of oscillation of the body of the sensor. When the sensor is used for scanning force microscopy, the influence of the interaction between the measuring tip of the sensor and the sample surface may have an influence on features of one or more of the elastic modes of oscillation. For example, the resonance frequency and/or the damping of one of more of the elastic modes of oscillation may be changed. In order to determine the interaction between the measuring tip and the surface of the sample to be investigated, it may be desirable to measure the influence of the interaction between the measuring tip and one of the elastic modes of oscillation of the body of the sensor, which will be denoted as "desired elastic mode of oscillation" in the following.

In the equivalent circuit diagram of Fig. 5, a modification of the resonance frequency and/or the damping of the desired elastic mode of oscillation may be modeled by a modification of the impedance of the circuit elements that constitute one of the resonance circuits 504, 505, 406 that is representative of the desired elastic mode of oscillation. For example, if the desired elastic mode of oscillation is represented by the resonance circuit 504, the influence of the interaction between the measuring tip and the sample surface on the desired elastic mode of oscillation may be modeled by an alteration of the inductivity 507, the capacity 510 and/or the resistance 513.

The desired elastic mode of oscillation may be an elastic mode of oscillation that is influenced by the interaction between the measuring tip and the sample surface to a relatively large extent, whereas other elastic modes of oscillation, which will be denoted as "undesirable elastic modes of oscillation" in the following, may be influenced by the interaction between the measuring tip and the sample surface to a less extent. Hence, features of the undesirable elastic modes of oscillation such as resonance frequency and/or damping may be altered to a less extent than corresponding features of the desired elastic mode of oscillation, or may remain substantially constant.

In the equivalent circuit 500, the relatively small influence of the interaction between the measuring tip and the sample surface on the undesirable elastic modes of oscillation may be modeled by substantially maintaining features of the circuit elements that constitute resonant circuits representative of the undesirable elastic modes of oscillation. Hence, the inductivities 508, 509, the capacities 511, 512 and the resistivities 514, 515 may be regarded as being substantially constant, irrespective of whether the measuring tip of the sensor interacts with the sample surface of not.

Moreover, the interaction between the sample surface and the measuring tip may affect the bulk capacity of the electromechanical element of the sensor to a small extent only, or may have substantially no influence on the bulk capacity at all. Hence, the capacity 503 in the equivalent circuit 500 may be considered as being substantially constant.

The alteration of the inductivity 507, the capacity 510 and the resistivity 513 that constitute the resonant circuit 504 representative of the desired elastic mode of oscillation may have an influence on the admittance of the resonant circuit 504 and thus, according to equation (6), on the admittance of the electromechanical element of the sensor. According to equation (9), this may have an influence on the current $I_3$ flowing through the secondary winding 303 of the transformer 301 and, thus, on the output voltage of the transimpedance amplifier 206. Hence, the output voltage of the transimpedance amplifier 206 can be representative of the strength of the interaction between the measuring tip and the sample surface.

In some embodiments of the present invention, the variable complex impedance 403 may be adjusted such that is approximately equal to a contribution of the bulk capacity 503 and the resonant circuits 505, 506 which are representative of the undesirable elastic modes of oscillation of the body of the sensor. If a k-th one of the resonant circuits 504, 505, 506 represents the desired elastic mode of oscillation, the variable complex impedance 403 may be adjusted to be approximately

$$Y_{comp} = j\omega C_{bulk} + \sum_{\substack{l=1 \\ l \neq k}}^{N} \big(G_l(\omega) + jB_l(\omega)\big) \qquad (10)$$

wherein the summation is performed only over the admittances of the resonant circuits 505, 506 which are representative of the undesirable elastic modes of oscillation of the body of the sensor.

Inserting equations (6) and (10) in equation (9), we obtain

$$I_3(\omega) = U(\omega)\big(G_k(\omega) + jB_k(\omega)\big) \qquad\qquad (11)$$

Hence, the current flowing through the secondary winding 303 of the transformer 301 and the output voltage of the transimpedance amplifier 206 may be representative of the contribution of the desired elastic mode of oscillation of the body of the sensor to the admittance of the sensor, whereas an influence of the bulk capacity of the electromechanical element and the undesirable elastic modes of oscillation of the body of the sensor may be compensated by the adjustment of the variable complex impedance 403.

In some embodiments, the variable complex impedance 403 can be adjusted such that its admittance is at least approximately equal to the admittance $Y_{comp}$ defined in equation (10) by means of the following method:

First, an AC voltage having a frequency that is lower than the resonance frequencies of all elastic modes of oscillation of the body of the sensor can be applied between the power source terminals 401, 402. In some embodiments, the AC voltage can have a frequency that is approximately equal to or less than 50% of the resonance frequency of the elastic mode of the body of the sensor having the lowest resonance frequency, irrespective of whether this is the desired elastic mode of oscillation of the body of the sensor or not.

The variable complex impedance 403 can then be adjusted such that the output voltage of the interface circuit 400 is substantially zero. In embodiments wherein the variable complex impedance 403 comprises a variable capacitor 404 and a variable resistor 405 electrically connected in parallel, this can be done by monitoring the output voltage of the interface circuit by means of a measuring instrument, for example an oscilloscope, and adjusting the variable capacitor 404 and the variable resistor 405 in such a manner that the output voltage is reduced. Thus, the DC resistance and the bulk capacity of the electromechanical element can be compensated for, at least approximately.

Thereafter, a frequency sweep can be performed to determine, at least approximately, the resonance frequency and the Q-factor of the desired elastic mode of oscillation of the sensor. For this purpose, an AC voltage can be applied between the power source terminals 401, 402. The frequency of the AC voltage can be varied, and the amplitude of the output voltage of the interface circuit 400 can be measured as a function of the frequency of the AC voltage, wherein the amplitude of the AC voltage is substantially maintained at the same value.

The amplitude of the output voltage of the interface circuit 400 comprises peaks, which correspond to the elastic modes of oscillation of the sensor. The frequency of the peaks is representative of the resonance frequencies of the elastic modes of oscillation, and the width of the peaks is representative of the Q-factor of the elastic modes of oscillation, wherein a greater Q-factor of an elastic mode of oscillation leads to a smaller width of the peak. Hence, resonance frequency and Q-factor of the desired elastic mode of oscillation can be determined from the frequency and the width of the peak corresponding to the desired elastic mode of oscillation.

Subsequently, an AC voltage having a frequency smaller than the resonance frequency of the desired elastic mode of oscillation (denoted as "lower frequency" in the following) and an AC voltage having a frequency greater than the resonance frequency of the desired elastic mode of oscillation (denoted as "upper frequency" in the following) can alternately be applied between the power source terminals 401, 402.

The lower frequency and the upper frequency can be outside the bandwidth of the desired elastic mode of oscillation of the body of the sensor. The bandwidth of the desired elastic mode oscillation of the body of the sensor is related to the Q-factor of the desired elastic mode of oscillation, wherein a greater Q-factor corresponds to a smaller bandwidth. The lower frequency and the upper frequency can be selected such that the desired elastic mode of oscillation of the body of the sensor is excited only to a small extent by the lower frequency and the upper frequency.

In some embodiments, the lower frequency and the upper frequency can be adapted such that the amplitude of the desired elastic mode of oscillation of the body of the sensor when excited at the lower frequency and the upper frequency is equal to or less than 1% of the amplitude of the desired mode of oscillation when excited with its resonance frequency. In some embodiments, to select the lower frequency and the upper frequency, the frequency response of a damped harmonic oscillator having the same resonance frequency and Q-factor as the desired elastic mode of oscillation can be calculated. The lower frequency can correspond to a frequency lower than the resonance frequency of the desired elastic mode of oscillation at which the amplitude of the harmonic oscillator obtains a predetermined value equal to or less than 1% of the amplitude of the desired elastic mode of oscillation at its resonance frequency, and the upper frequency can correspond to a frequency greater than the resonance frequency at which the amplitude of the harmonic resonator obtains the predetermined value.

Thereafter, the variable complex impedance 403 can be adjusted such that the amplitude of the output voltage of the interface circuit 400 at the lower frequency and the upper frequency is minimized or at least reduced. In embodiments wherein the variable complex impedance 403 comprises a variable capacitor 404 and a variable resistor 405, this can be done by changing the capacity of the variable capacitor 404 and the resistance of the variable resistor 405.

In other embodiments of the present invention, the variable complex impedance 403 may be adjusted such that it is substantially equal to the impedance provided by the bulk capacity 503 of the electromechanical element of the sensor. In embodiments wherein the variable complex impedance 403 comprises a variable capacitor 404 and a variable resistor 405 electrically connected in parallel, this can be done by adjusting the variable capacitor 404 to provide a capacitance substantially equal to the bulk capacity of the electromechanical element and by adjusting the variable resistor 405 to provide a resistance substantially equal to a leakage resistance of the electromechanical element. The capacitance and the leakage resistance of the electromechanical element may be measured by means of methods of measuring the DC capacitance and leakage resistance of a capacitor known to persons skilled in the art.

In other embodiments, the variable capacitance 404 and the variable resistance 405 may be adjusted by applying an AC voltage having a frequency that is different from the frequency of operation of the sensor to the power source terminals 401, 402, and the variable capacitor 404 and the variable resistor 405 may be adjusted such that the output voltage of the transimpedance amplifier 206 is substantially zero. According to equation (9), a substantially zero output voltage of the transimpedance amplifier may imply that the impedances of the variable complex impedance 403 and the electromechanical element of the sensor are substantially equal.

In some embodiments, the adjustment of the variable capacitor 404 and the variable resistor may be performed at a relatively low frequency of the voltage applied to the power source terminals 401, 402, for example at 50% of the resonance frequency of the elastic mode of oscillation of the body of the sensor having the smallest resonance frequency or less, irrespective of whether this is the desired elastic mode of oscillation or not. Thus, the variable capacitor 404 and the variable resistor 405 can be adjusted to provide a capacity and a resistance, respectively, corresponding to the DC capacity and the DC resistance, respectively, of the electromechanical element of the sensor.

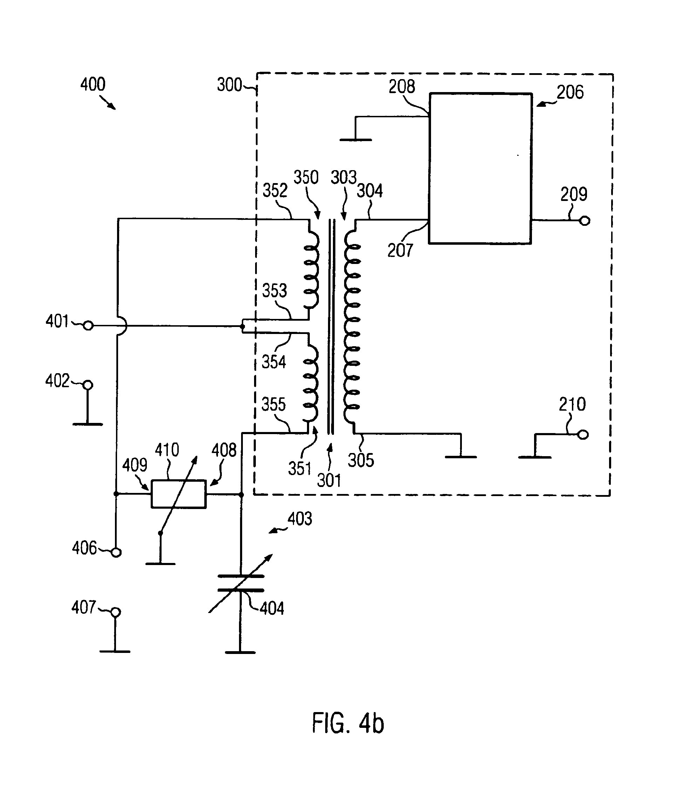

Fig. 4b shows an interface circuit 450 according to another embodiment of the present invention. The interface circuit 450 comprises a first variable resistance 408 that is electrically connected in parallel to a variable capacitor 404. The first variable resistance 408 and the variable capacitance 404 form a variable complex impedance 403 that is electrically connected between the fourth primary winding terminal 355 and the second power source terminal 402. The second variable resistance 410 is electrically connected between the first sensor terminal 406 and the second sensor terminal 407. In some embodiments, the first variable resistance 408 and the second variable resistance 409 may be provided in form of a potentiometer 410 that is electrically connected between the first sensor terminal and the fourth primary winding terminal 355, wherein a wiper of the potentiometer is electrically connected to the second sensor terminal 407, for example by connecting both the wiper of the potentiometer 410 and the second sensor terminal 407 to ground. In other embodiments, other circuit elements may be used to provide the first variable resistance 408 and the second variable resistance 409. Further features of the interface circuit 450 may correspond to those of the interface circuit 400 described above with respect to Fig. 4a.

The interface circuit 450 allows a simple compensation of a small real part of the admittance of the sensor, and also allows a compensation of a negative real part of the admittance of the sensor corresponding to a generation of electric voltage in the sensor. Thus, a true four-quadrant compensation, i.e., on both sides of the imaginary axis and both sides of the real axis, of contributions of undesirable elastic modes of oscillation of the body of the sensor to the admittance of the sensor can be performed.

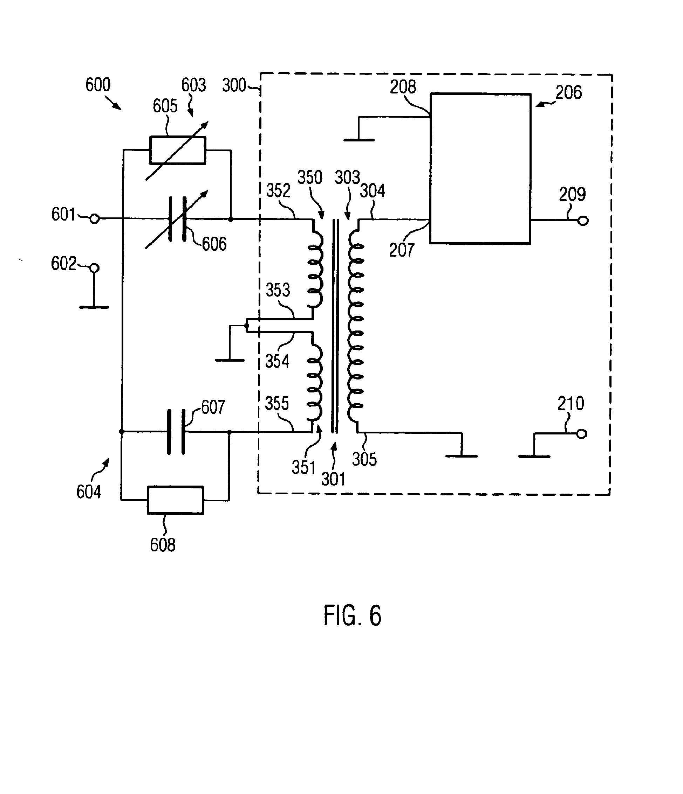

Fig. 6 shows a schematic circuit diagram of a phase shifter 600 according to an embodiment of the present invention. The phase shifter 600 comprises an electric circuit 300 as described above with reference to Fig. 3.

In addition to the electric circuit 300, the phase shifter 600 comprises a first phase shifter input terminal 601 and a second phase shifter input terminal 602 which are adapted for electrical connection of the phase shifter 600 to an AC voltage source. The phase shifter 600 further comprises a first complex impedance 603 which is electrically connected between the first phase shifter input terminal 601 and the first primary winding terminal 352 and a second complex impedance 604 electrically connected between the first phase shifter input terminal 601 and the fourth primary winding terminal. The second primary winding terminal 353 and the third primary winding terminal 354 are electrically connected to the second phase shifter input terminal 602. In some embodiments, this can be done by connecting the second phase shifter input terminal 602, the second primary winding terminal 353 and the fourth primary winding terminal 354 to ground. In other embodiments, electrically conductive lines may be connected between the second phase shifter input terminal 602 and the second primary winding terminal 353 as well as the third primary winding terminal 354.

In some embodiments, the first primary winding 350 and the second primary winding 351 of the transformer 301 can be provided in form of a single coil having a center tap, wherein the second phase shifter input terminal 602 is electrically connected to the center tap. In other embodiments, the first primary winding 350 and the second primary winding 351 may be provided in form of two separate coils.

The phase shifter 600 further comprises means for providing the output voltage of the transimpedance amplifier 206 as an output voltage of the phase shifter. Such means can be provided in form of the output terminal 209 and the grounded terminal 210, or in form of electrically conductive lines connected thereto.

The first complex impedance 603 may comprise a variable ohmic resistor 605 and a variable capacitor 606 electrically connected in parallel. The second complex impedance 604 can comprise a capacitor 607 and an ohmic resistor 608 electrically connected in parallel. In some embodiments, the capacitance of the capacitor 607 and the resistance of the ohmic resistor 607 may be fixed. In other embodiments, the capacitor 607 and/or the ohmic resistance 608 may be variable. In still further embodiments, a fixed capacitor and a fixed resistor may be provided instead of the variable capacitor 606 and the variable resistor 604.

In the operation of the phase shifter 600, an AC voltage may be applied between the phase shifter input terminals 601, 602. The AC voltage may cause an electric current flowing from the first phase shifter input terminal 601 to the second phase shifter input terminal via the first complex impedance 603 and the first primary winding 350. If the current direction is from the first phase shifter input terminal 601 to the second phase shifter input terminal 602, current flow in the first primary winding 350 is from the first primary winding terminal 353 to the second primary winding terminal 352. Hence, the sign of the first electric current flowing through the first primary winding 350, which was defined as being positive if current flow is from the first primary winding terminal 352 to the second primary winding terminal 353, is identical to the sign of the electric current flowing from the first phase shifter input terminal 601 to the second phase shifter input terminal 602 via the first complex impedance 602 and the first primary winding 350.

The AC voltage applied between the phase shifter input terminals 601, 602 may also cause an electric current flowing from the first phase shifter input terminal 601 to the second phase shifter input terminal 602 via the second complex impedance 604 and the second primary winding 351. If the current direction of this current is from the first phase shifter input terminal 601 to the second phase shifter input terminal 602, current flow in the second primary winding 351 is from the fourth primary winding terminal 355 to the third primary winding terminal 354. Since the sign of the second electric current flowing through the second primary winding 351 was defined as being positive if the current direction is from the third primary winding terminal 354 to the fourth primary winding terminal 355, the sign of the second electric current is opposite to the sign of the electric current flowing from the first phase shifter input terminal 601 to the second phase shifter input terminal 602 via the second complex impedance 604 and the second primary winding 351.

From equation (5), we obtain:

$$I_3(\omega) = U(\omega)\left[G_{604}(\omega) - G_{603}(\omega) + j\left(B_{604}(\omega) - B_{603}(\omega)\right)\right] \tag{12}$$

wherein $U(\omega)$ denotes the AC voltage of angular frequency $\omega$ applied between the phase shifter input terminals 601, 602, $G_{604}$ and $B_{604}$ denote the real and imaginary part, respectively, of the admittance of the second complex impedance 604, and $G_{603}$ and $B_{603}$ denote the real and the imaginary part, respectively, of the admittance of the first complex impedance.

In embodiments wherein each of the first complex impedance 603 and the second complex impedance 604 comprises a capacitor and an ohmic resistor electrically connected in parallel, the real parts $G_{603}$, $G_{604}$ of the admittances of the complex impedances 603, 604 may be approximately equal to the reciprocal values of the ohmic resistivities 605, 608, respectively, and the imaginary parts $B_{603}$, $B_{604}$, respectively, may be substantially equal to a product of the angular frequency $\omega$ and the capacities 606, 607, respectively. Depending on which of the real parts $G_{604}$, $G_{603}$ is greater, the real part of the term in brackets of equation (12) may be positive or negative. Depending on which of the imaginary parts $B_{604}$, $B_{603}$ is greater, the imaginary part of the term in brackets of equation (12) may be positive or negative.

Thus, a phase shift between the voltage $U(\omega)$ applied between the phase shifter input terminals 601, 602 and the current $I_3$ flowing through the secondary winding 303 of the transformer 301 and, correspondingly, the output voltage of the transimpedance amplifier 206 may be in one of the four quadrants of the plane of complex numbers, depending on the relationship between the real and imaginary parts of the admittances of the complex impedances. Moreover, a relationship between the amplitude of the output voltage of the transimpedance amplifier 206 and the amplitude of the AC voltage applied to the phase shifter input terminals 601, 602 may be influenced by relationships between real and imaginary parts of the first complex impedance 603 and the second complex impedance 604.

In embodiments wherein one or both of the first complex impedance 603 and the second complex impedance 604 is variable, one or both of the first complex impedance 603 and the second complex impedance 604 may be adjusted to obtain a desired phase shift between the AC voltage applied to the phase shifter input terminals 601, 602, and a desired relationship between the output voltage of the transimpedance amplifier 206 and the AC voltage applied to the phase shifter input terminals 601, 602. In embodiments wherein both complex impedances 603, 604 are fixed, the complex impedances 603, 604 may be preselected to provided a desired phase shift and amplitude relationship at a desired frequency of operation.

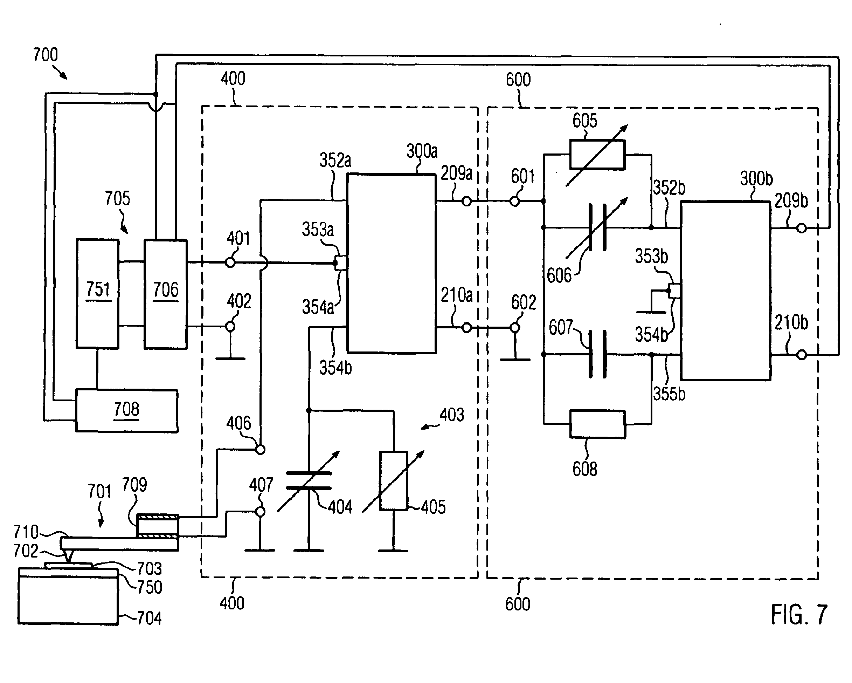

Fig. 7 shows a schematic sketch of a scanning force microscope 700 according to an embodiment of the present invention. The scanning force microscope 700 comprises a sensor 701 comprising a body 710 having at least one elastic mode of oscillation, an electromechanical element 709 adapted to excite elastic oscillations of the body 710 which may, in some embodiments, be integral with the body 710. and a measuring tip 702. In some embodiments, features of the sensor 701 may correspond to those of the sensor 110 described above with reference to Fig. 1. In other embodiments, the sensor may have a configuration corresponding to that disclosed in European Patent Application No. 08009133.3 or a configuration corresponding to that disclosed in European Patent Application No. 08009131.7.

The scanning force microscope 700 further comprises a positioner 704 for moving the sensor 701 relative to a sample 703 to be investigated by means of the scanning force microscope 700. The sample 703 may be provided in a sample holder 750 connected to the positioner 704. Features of the positioner 704 and the sample holder 750 may correspond to those of the positioner 106 and the sample holder 105 described above with reference to Fig. 1.

Additionally, the scanning force microscope 700 comprises an interface circuit. In some embodiments, the interface circuit can be an interface circuit 400, as described above with reference to Fig. 4a. In other embodiments, the interface circuit can be an interface circuit 450 as described above with reference to Fig. 4b.

In some embodiments, the body 710 of the sensor 701 can have one or more undesirable elastic modes of oscillation having a resonance frequency that differs from a resonance frequency of a desired elastic mode of oscillation of the body 710 by at least 10%, by at least 20% and/or by at least 50%. Additionally, or alternatively, a Q-factor of the undesirable elastic modes of oscillation can be smaller than the Q-factor of the desired elastic mode of oscillation by at least a factor of 3, at least a factor of 20 and/or at least a factor of 100. This may simplify an adjustment of the interface circuit 400, 450 in accordance with the method described above. The resonance frequencies and the Q-factors of the elastic modes of oscillation of the body 710 of the sensor 701 can be controlled by varying the dimensions of components of the sensor 701 and/or the material of materials from which the sensor 701 is formed.

Moreover, the scanning force microscope 700 may comprise a phase shifter 600, as described above with reference to Fig. 6. Both the interface circuit 400 and the phase shifter 600 may comprise an electric circuit as described above with reference to Fig. 3. In Fig. 7, the electric circuit of the interface circuit 400 is denoted by reference numeral 300a, and components thereof are denoted by reference numerals having a trailing "a". The electric circuit of the phase shifter 600 is denoted by reference numeral 300b, and components thereof are denoted by reference numerals having a trailing b. Otherwise, like reference numerals have been used in Figs. 3, 4a, 4b, 6 and 7, to denote like components. For simplicity, some components of the electric circuits 300a, 300b are not shown in Fig. 7.

The electromechanical element 709 may be electrically connected between the sensor terminals 406, 407 of the interface circuit 400. The output voltage of the transimpedance amplifier of the electric circuit 300a of the interface circuit 400 may be applied between the first phase shifter input terminal 601 and the second phase shifter input terminal 602 of the phase shifter 600, for example by means of electrically conductive lines connecting the terminals 109a, 210a of the electric circuit 300a to the phase shifter input terminals 601, 602.

The scanning force microscope 700 may further comprise an oscillator 705 adapted to provide an AC voltage. In some embodiments, the oscillator 705 may comprise a function generator 751 configured to provide a sinusoidal output voltage having a desired frequency. The output voltage of the function generator may be supplied to a superposition circuit 706 adapted to superimpose the output voltage of the oscillator 705 with the output voltage of the phase shifter 600 and to provide an output voltage representative of the superposition. The output voltage of the superposition circuit 706 may then be applied between the power source input terminals 401, 402 of the interface circuit 400. In some embodiments, a buffer circuit for reducing the output impedance of the superposition circuit 706 may be connected between the superposition circuit 706 and the power source terminals 401, 402.

In some embodiments, the superposition circuit 706 may comprise a superposition circuit as described above with reference to Fig. 3.

The scanning force microscope 700 may further comprise a controller 708 receiving the output voltage of the phase shifter 600 and/or the output voltage of the interface circuit 400. Moreover, the controller 708 may be connected to the function generator 751 for controlling an amplitude and/or frequency of the output voltage of the function generator 751, and may also be connected to the positioner 704 for controlling a motion of the sample holder 750 relative to the sensor 701. In some embodiments, the controller 708 may comprise a computer of a type known to persons skilled in the art and equipped with an interface circuit for connection of the computer to the function generator 751 and the positioner 704 and for receiving the output voltage of the interface circuit 400 and/or the phase shifter 600.

In the operation of the scanning force microscope 700, the variable complex impedance 403 of the interface circuit 400 may be adjusted such that the output voltage of the interface circuit 400 is representative of the desired elastic mode of oscillation of the body 710 of the sensor 700. In other embodiments, the variable capacitor 404 and the variable resistor 405 may be adjusted such that the capacitance of the variable capacitor 404 is approximately equal to the DC capacitance of the electromechanical element 709 of the sensor and the resistivity of the variable resistor 405 is approximately equal to the leakage resistance of the electromechanical element 709.

The phase shifter 600 may be adapted such that a desired phase shift between the output voltage of the phase shifter 400 and the output voltage of the interface circuit 400 is obtained. In embodiments wherein at least one of the complex impedances 603, 604 of the phase shifter 600 is variable, this can be done by adjusting one or both of the complex impedances 603, 604. For this purpose, the phase shift between the output voltages of the interface circuit 400 and the output voltage of the phase shifter 400 can be measured by means of known methods, for example by displaying both output voltages on the screen of an oscilloscope.

In some embodiments, the phase shift provided by the phase shifter 600 can be set such that a positive feedback of the elastic oscillation of the body 710 of the sensor 701 is obtained. Since the output voltage of the interface circuit 400 and, hence, also the output voltage of the phase shifter 600 can be representative of a response of the desired elastic mode of oscillation of the body 710 of the sensor 701 to the AC voltage applied to the power source terminals 401, 402, whereas a response of undesirable elastic modes of oscillation may be suppressed by the interface circuit 400, the feedback may selectively enhance the Q-factor of the desired elastic mode of oscillation.] Hence, the Q-factor, which influences measurement speed and force, becomes a user-settable parameter that can be adapted to the needs of a scanning force microscope, even if the Q factor of the pure mechanical structure deviates from the desired value.

After the adjustments of the variable complex impedances 403, 603 in the interface circuit 400 and the phase shifter 600, the sample 703 may be investigated by means of scanning force microscopy. For this purpose, the sample 703 may be inserted into the sample holder 750 connected to the positioner 704, and the surface of the sample 703 may be scanned by the measuring tip 702. In the scanning process, the sample 703 may be moved relative to the sensor 701 in one or more horizontal directions. Thereby, the measuring tip 702 may interact with the surface of the sample 703.

The interaction of the measuring tip 702 may have an influence on the output voltage of the interface circuit 400, as well as on the output voltage of the phase shifter 600 connected thereto. A distance between the sample holder of the positioner 704 can be controlled on the basis of the output voltage of the interface circuit 400 and/or on the basis of the output voltage of the phase shifter 600, which can be representative of the output voltage of the interface circuit 400. For this purpose, the sample holder may be moved in a vertical direction substantially perpendicular to the one or more horizontal scanning directions towards the measuring tip 702 or away from the measuring tip 702 in such a manner that the output voltage of the interface circuit 400 and/or the output voltage of the phase shifter 600 are maintained substantially constant while the surface of the sample 703 is scanned. This can be done by means of the controller 708.

A quantity representative of the distance between the sample holder 750 and the measuring tip 702 can be measured during the scanning process to determine properties of the surface of the sample 703. In some embodiments, the distance between the sample holder 750 and the measuring tip 702 can be controlled by moving the sensor 701 in the vertical direction. In such embodiments, the distance between the sample holder 750 and the measuring tip 702 can be determined by interferometrically measuring the position of the sensor 701, for example by means of methods and devices as described in European Patent Application No. 08016297.7. The distance between the sample holder 750 and the measuring tip 702 may be representative of properties of the surface of the sample 703, for example of a surface profile of the sample 703. Thus, properties of the surface of the sample 703 may be measured by means of the scanning force microscope 700.

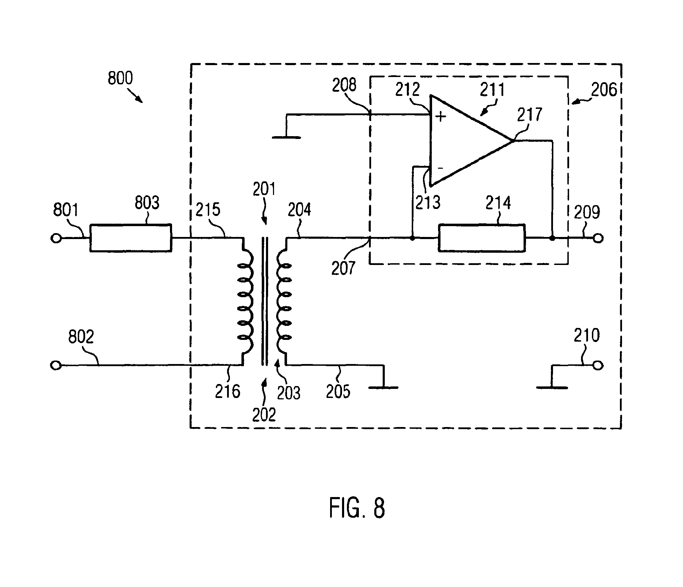

Fig. 8 shows a schematic circuit diagram of a voltage to voltage decoupler 800 according to an embodiment of the present invention. The voltage to voltage decoupler 800 comprises an electric circuit 200 as described above with reference to Fig. 2. Additionally, the voltage to voltage decoupler 800 comprises a resistor 803 electrically connected in series with the primary winding 202. For this purpose, a first terminal of the resistor 803 may be electrically connected to the first primary winding terminal 215. The voltage to voltage decoupler 800 further comprises means for applying an input voltage of the voltage to voltage decoupler 800 to the series connection of the resistor 803 and the primary winding 202, for example terminals 801, 802 electrically connected to a second terminal of the resistor 803 and the second primary winding terminal 216. In other embodiments, the means for applying the input voltage of the voltage to voltage decoupler 800 to the series connection of the resistor 803 and the primary winding 202 may be provided in form of the second terminal of the resistor 803 and the second primary winding terminal 216.

The voltage to voltage decoupler 800 further comprises means for providing the output voltage of the transimpedance amplifier 206 as the output voltage of the voltage to voltage converter 800. Such means may be provided in form of the terminals 209, 210 of the circuit 200, or in form of electrically conductive lines electrically connected thereto.

As detailed above, the output voltage of the transimpedance amplifier 206 may be approximately equal to a product of the resistivity of the resistor 214 in the transimpedance amplifier 206 and the amperage of the current flowing through the secondary winding 203 of the transformer 201.

If an electric voltage is applied to the terminals 801, 802 of the voltage to voltage converter 800, an electric current may flow through the resistor 803 and the primary winding 202 of the transformer 201. The amperage of this electric current may be approximately equal to a ratio between the voltage applied to the terminals 801, 802 and the resistivity of the resistor 803.

Hence, if the resistivities of the resistors 803, 214 are substantially equal, and the number of turns of the primary winding 202 of the transformer 201 is equal to the number of turns of the secondary winding 203, the output voltage of the transimpedance amplifier 206 may be substantially equal to the AC component of the voltage applied to the terminals 801, 802 of the voltage to voltage decoupler 800.

Although some embodiments of the present invention have been described in the context of scanning microscopy techniques such as scanning force microscopy, the present invention is not limited to such embodiments. In other embodiments, a measuring instrument other than a scanning force microscope that comprises a sensor having a body and a measuring tip connected to the body, as well as an electromechanical element adapted to excite an elastic oscillation of the body can be used. For example, the measuring instrument can be a coordinate measuring machine wherein a sample that may, for example, be a workpiece whose shape is to be determined, is scanned by means of an oscillating measuring tip.

**Claims**

1. An interface circuit (400, 450) for a measuring instrument, said measuring instrument comprising a sensor, said sensor comprising a body having a measuring tip connected thereto and an electromechanical element adapted to excite an elastic oscillation of said body, said interface circuit comprising:

   a first electric circuit (300), said first electric circuit (300) comprising:

      a transformer (301) having a secondary winding (303), said secondary winding (303) having a first secondary winding terminal (304) and a second secondary winding terminal (305), a first primary winding (350) and a second primary winding (351), said first primary winding (350) comprising a first primary winding terminal (352) and a second primary winding terminal (353), said second primary winding (351) comprising a third primary winding terminal (354) and a fourth primary winding terminal (355), wherein said first primary winding (350) and said second primary winding (351) are adapted such that an electric current flowing from said first primary winding terminal (352) to said second primary winding terminal (353) and an electric current flowing from said third primary winding terminal (354) to said fourth primary winding terminal (355) create a magnetic flux in the same direction in said secondary winding (303);
      a transimpedance amplifier (206) having a first amplifier input terminal (207) and a second amplifier input terminal (208), said first amplifier input terminal (207) being electrically connected to said first secondary winding terminal (204, 304), said second amplifier input terminal (208) being electrically connected to said second secondary winding terminal (205, 305), wherein said transimpedance amplifier (206) is adapted to output a voltage representative of a current flowing through said secondary winding (203, 303);
   the interface circuit further comprising:

      a first power source terminal (401) and a second power source terminal (402) adapted for connection of said interface circuit (400, 450) to a power source providing an AC voltage; and
      a variable complex impedance (403);
      wherein said first power source terminal (401) is connected to said second primary winding terminal (353) and said third primary winding terminal (354);
      wherein said variable complex impedance (403) is connected between said second power source terminal (402) and said fourth primary winding terminal (355); and
      wherein said interface circuit (400, 450) further comprises: a first sensor terminal (406) and a second sensor terminal (407) adapted for electrical connection of said electromechanical element of said sensor between said first sensor terminal (406) and said second sensor terminal (407), wherein said first sensor terminal (406) is electrically connected to said first primary winding terminal (352) and wherein said second sensor terminal (407) is electrically connected to said second power source terminal (402); and
      means (209, 210) for providing said output voltage of said transimpedance amplifier (206) as an output voltage of said interface circuit (400, 450).

2. An interface circuit (400, 450) according to claim 1, wherein the first (350) and second (351) primary windings are provided in forms of coils or portions of a single coil having a center tap.

3. An interface circuit according to claim 1 or 2, wherein said variable complex impedance (403) comprises a variable capacitor (404) and a first variable resistor (405, 408) connected in parallel.

4. An interface circuit according to claim 3, further comprising a second variable resistor (409) electrically connected between said first sensor terminal (406) and said second sensor terminal (407).

5. A measuring instrument (700) comprising:

a sensor (701), said sensor (701) comprising a body (710) having a measuring tip (702) connected thereto and an electromechanical element (709) adapted to excite an elastic oscillation of said body (710);

an interface circuit (400) according to any of claims 1 to 4, wherein said electromechanical element (709) of said sensor (701) is connected between said first sensor terminal (406) and said second sensor terminal (407) of said interface circuit (700),

a phase shifter (600), said phase shifter (600) comprising:

a second electric circuit (300), said second electric circuit comprising:

a transformer (301) having a secondary winding (303), said secondary winding (303) having a first secondary winding terminal (304) and a second secondary winding terminal (305), a first primary winding (350) and a second primary winding (351), said first primary winding (350) comprising a first primary winding terminal (352) and a second primary winding terminal (353), said second primary winding (351) comprising a third primary winding terminal (354) and a fourth primary winding terminal (355), wherein said first primary winding (350) and said second primary winding (351) are adapted such that an electric current flowing from said first primary winding terminal (352) to said second primary winding terminal (353) and an electric current flowing from said third primary winding terminal (354) to said fourth primary winding terminal (355) create a magnetic flux in the same direction in said secondary winding (303);

a transimpedance amplifier (206) having a first amplifier input terminal (207) and a second amplifier input terminal (208), said first amplifier input terminal (207) being electrically connected to said first secondary winding terminal (204, 304), said second amplifier input terminal (208) being electrically connected to said second secondary winding terminal (205, 305), wherein said transimpedance amplifier (206) is adapted to output a voltage representative of a current flowing through said secondary winding (203, 303), said phase shifter further comprising:

a first phase shifter input terminal (601) and a second phase shifter input terminal (602) adapted for electrical connection to an AC voltage source;

a first complex impedance (603) electrically connected between said first phase shifter input terminal (601) and said first primary winding terminal (352);

a second complex impedance (604) electrically connected between said first phase shifter input terminal (601) and said fourth primary winding terminal (355); and

means (209, 210) for providing said output voltage of said transimpedance amplifier (206) as an output voltage of said phase shifter (600);

wherein said second phase shifter input terminal (602) is electrically connected to said second primary winding terminal (353) and said third primary winding terminal (354); said measuring instrument further comprising:

means (209a, 210a) for applying said output voltage of said interface circuit (400) between said first phase shifter input terminal (601) and said second phase shifter input terminal (602) of said phase shifter (600);

an oscillator (705) adapted to provide an AC voltage;

means (706) for superimposing said output voltage of said phase shifter (600) and said AC voltage provided by said oscillator (705) to form a superposition voltage and for applying said superposition voltage between said first power source terminal (401) and said second power source terminal (402) of said interface circuit (400).

6. A measuring instrument (700) as in claim 5, wherein each of said first complex impedance (603) of said phase shifter (600) and said second complex impedance (604) of said phase shifter (600) comprises a capacitor (606, 607) and a resistor (605, 608) connected in parallel.

7. A measuring instrument (700) as in claim 5 or 6, wherein at least one of said first complex impedance (603) of said phase shifter (600) and said second complex impedance (604) of said phase shifter (600) is a variable complex impedance.

8. A method of operating a measuring instrument (700) comprising sample holder (750), a sensor (701), said sensor (701) comprising a body (710) having a measuring tip (702) connected thereto and an electromechanical element (709) adapted to excite an elastic oscillation of said body (710), said measuring instrument (700) further comprising an interface circuit (400) according to any of claims 1 to 4, wherein said electromechanical element (709) of said sensor is electrically connected between said first sensor terminal (406) and said second sensor terminal (407) of said interface circuit (400), said method comprising:

applying one or more first AC voltages between said first power source terminal (401) and said second power source terminal (402) of said interface circuit (400), each of said one or more first AC voltages having a frequency outside a bandwidth of a desired elastic mode of oscillation of said body (710);

adjusting said variable complex impedance (403) of said interface circuit to reduce the output voltage of said interface circuit (400) obtained in response to said one or more first AC voltages;

inserting a sample (703) to be investigated into said sample holder (750);

after adjusting said variable complex impedance (403) of said interface circuit (400) and after inserting said sample (703) to be investigated into said sample holder (750), applying a second AC voltage having a frequency within said bandwidth of said desired elastic mode of oscillation of said body (710), scanning a surface of said sample (703) to be investigated with said measuring tip (702) of said sensor (701), wherein a distance between said sample holder (750) and said measuring tip (702) is controlled on the basis of the output voltage of said interface circuit (400) obtained in response to said second AC voltage and wherein a quantity representative of said distance between said sample holder (750) and said measuring tip (702) is measured.

9. A method of operating a measuring instrument (700) as in claim 8, further comprising:

providing a phase shifter (600), said phase shifter (600) comprising:

a second electric circuit (300), said second electric circuit comprising:

a transformer (301) having a secondary winding (303), said secondary winding (303) having a first secondary winding terminal (304) and a second secondary winding terminal (305), a first primary winding (350) and a second primary winding (351), said first primary winding (350) comprising a first primary winding terminal (352) and a second primary winding terminal (353), said second primary winding (351) comprising a third primary winding terminal (354) and a fourth primary winding terminal (355), wherein said first primary winding (350) and said second primary winding (351) are adapted such that an electric current flowing from said first primary winding terminal (352) to said second primary winding terminal (353) and an electric current flowing from said third primary winding terminal (354) to said fourth primary winding terminal (355) create a magnetic flux in the same direction in said secondary winding (303); and a transimpedance amplifier (206) having a first amplifier input terminal (207) and a second amplifier input terminal (208), said first amplifier input terminal (207) being electrically connected to said first secondary winding terminal (204, 304), said second amplifier input terminal (208) being electrically connected to said second secondary winding terminal (205, 305), wherein said transimpedance amplifier (206) is adapted to output a voltage representative of a current flowing through said secondary winding (203, 303), said phase shifter further comprising:

a first phase shifter input terminal (601) and a second phase shifter input terminal (602) adapted for electrical connection to an AC voltage source;

a first complex impedance (603) electrically connected between said first phase shifter input terminal (601) and said first primary winding terminal (352);

a second complex impedance (604) electrically connected between said first phase shifter input terminal (601) and said fourth primary winding terminal (355); and

means (209, 210) for providing said output voltage of said transimpedance amplifier (206) as an output voltage of said phase shifter (600);

wherein said second phase shifter input terminal (602) is electrically connected to said second primary winding terminal (353) and said third primary winding terminal (354), said method of operating a measuring instrument further comprising:

applying said output voltage of said interface circuit (400) between said first phase shifter input terminal (601) and said second phase shifter input terminal (602) of said phase shifter (600);

adjusting said variable complex impedance (603) of said phase shifter (600) to obtain a desired phase difference between said output voltage of said phase shifter (600) and said output voltage of said interface circuit (400);

superimposing said output voltage of said phase shifter (600) and an AC signal having a predetermined frequency and amplitude to form a superposition voltage; and

applying said superposition voltage between said first power source terminal (401) and said second power source terminal (402) as said second AC voltage.

**Patentansprüche**

1. Ein Schnittstellenschaltkreis (400, 450) für ein Messinstrument, wobei das Messinstrument einen Sensor umfasst, der einen Körper mit einer damit verbundenen Messspitze und ein elektromechanisches Element, dass dafür ausgelegt ist, eine elastische Schwingung der Körpers anzuregen, umfasst, wobei der Schnittstellenschaltkreis umfasst:

   einen ersten elektrischen Schaltkreis (300), wobei der erste elektrische Schaltkreis (300) umfasst:

      einen Transformator (301) mit einer Sekundärwicklung (303), die einen ersten Sekundärwicklungsanschluss (304) und einen zweiten Sekundärwicklungsanschluss (305) umfasst, einer ersten Primärwicklung (350) und einer zweiten Primärwicklung (351), wobei die erste Primärwicklung (350) einen ersten Primärwicklungsanschluss (352) und einen zweiten Primärwicklungsanschluss (353) umfasst, und die zweite Primärwicklung (351) einen dritten Primärwicklungsanschluss (354) und einen vierten Primärwicklungsanschluss (355) umfasst, und wobei die erste Primärwicklung (350) und die zweite Primärwicklung (351) derart ausgelegt sind, dass ein elektrischer Strom, der vom ersten Primärwicklungsanschluss (352) zum zweiten Primärwicklungsanschluss (353) fließt und ein elektrischer Strom, der von dem dritten Primärwicklungsanschluss (354) zum vierten Primärwicklungsanschluss (355) fließt, in der Sekundärwicklung (303) einen Magnetfluss in der gleichen Richtung erzeugen;
      einen Transimpedanzverstärker (206) mit einem ersten Verstärkereingangsanschluss (207) und einem zweiten Verstärkereingangsanschluss (208), wobei der erste Verstärkereingangsanschluss (207) elektrisch mit dem ersten Sekundärwicklungsanschluss (204, 304) verbunden ist, der zweite Verstärkereingangsanschluss (208) elektrisch mit dem zweiten Sekundärwicklungsanschluss (205, 305) verbunden ist, und der Transimpedanzverstärker (206) dafür ausgelegt ist, eine Spannung auszugeben, die einen durch die Sekundärwicklung (203, 303) fließenden Strom darstellt;
      wobei der Schnittstellenschaltkreis außerdem umfasst:

         einen ersten Stromquellenanschluss (401) und einen zweiten Stromquellenanschluss (402), die zum Verbinden des Schnittstellenschaltkreises (400, 450) mit einer Stromquelle, die eine Wechselspannung bereitstellt, ausgelegt sind;
         eine veränderbare komplexe Impedanz (403);
         wobei der erste Stromquellenanschluss (401) mit dem zweiten Primärwicklungsanschluss (353) und dem dritten Primärwicklungsanschluss (354) verbunden ist;
         wobei die veränderbare komplexe Impedanz (403) zwischen dem zweiten Stromquellenanschluss (402) und dem vierten Primärwicklungsanschluss (355) verbunden ist; und
         wobei der Schnittstellenschaltkreis (400, 450) ferner einen ersten Sensoranschluss (406) und einen zweiten Sensoranschluss (407) umfasst, die zum elektrischen Verbinden des elektromechanischen Elements des Sensors zwischen dem ersten Sensoranschluss (406) und dem zweiten Sensoranschluss (407) ausgelegt sind, wobei der erste Sensoranschluss (406) elektrisch mit dem ersten Primärwicklungsanschluss (352) verbunden ist und der zweite Sensoranschluss (407) elektrisch mit dem zweiten Stromquellenanschluss (402) verbunden ist; und
         Mittel (209, 210) zum Bereitstellen der Ausgangsspannung des Transimpedanzverstärkers (206) als eine Ausgangsspannung des Schnittstellenschaltkreises (400, 450).

2. Ein Schnittstellenschaltkreis (400, 450) gemäß Anspruch 1, wobei die erste (350) und die zweite (351) Primärwicklung in Form von Spulen oder Teilen einer einzelnen Spule mit einem Mittelabgriff bereitgestellt sind.

3. Ein Schnittstellenschaltkreis gemäß Anspruch 1 oder 2, wobei die veränderbare komplexe Impedanz (403) einen veränderbaren Kondensator (404) und einen ersten veränderbaren Widerstand (405, 408), die parallel geschaltet sind, umfasst.

4. Ein Schnittstellenschaltkreis gemäß Anspruch 3, der zusätzlich einen zweiten veränderbaren Widerstand (409) umfasst, der elektrisch zwischen dem ersten Sensoranschluss (406) und dem zweiten Sensoranschluss (407) verbunden ist.

5. Ein Messinstrument (700) mit :

einem Sensor (701) der einen Körper (710) mit einer damit verbundenen Messspitze (702) und ein elektromechanisches Element (709), das dafür ausgelegt ist, eine elastische Schwingung des Körpers (710) anzuregen, umfasst;
einem Schnittstellenschaltkreis (400) gemäß einem der Ansprüche 1 bis 4, wobei das elektromechanische Element (709) des Sensors (701) zwischen dem ersten Sensoranschluss (406) und dem zweiten Sensoranschluss (407) des Schnittstellenschaltkreises (700) verbunden ist;
einem Phasenschieber (600), wobei der Phasenschieber (600) umfasst:

einen zweiten elektrischen Schaltkreis (300), wobei der zweite elektrische Schaltkreis umfasst:

einen Transformator (301) mit einer Sekundärwicklung (303), die einen ersten Sekundärwicklungsanschluss (304) und einen zweiten Sekundärwicklungsanschluss (305) umfasst, einer ersten Primärwicklung (350) und einer zweiten Primärwicklung (351), wobei die erste Primärwicklung (350) einen ersten Primärwicklungsanschluss (352) und einen zweiten Primärwicklungsanschluss (353) umfasst, wobei die zweite Primärwicklung (351) einen dritten Primärwicklungsanschluss (354) und einen vierten Primärwicklungsanschluss (355) umfasst, und wobei die erste Primärwicklung (350) und die zweite Primärwicklung (351) derart ausgelegt sind, dass ein elektrischer Strom, der vom ersten Primärwicklungsanschluss (352) zum zweiten Primärwicklungsanschluss (353) fließt und ein elektrischer Strom, der vom dritten Primärwicklungsanschluss (354) zum vierten Primärwicklungsanschluss (355) fließt, in der Sekundärwicklung (303) einen Magnetfluss in der gleichen Richtung erzeugen;
einen Transimpedanzverstärker (206) mit einem ersten Verstärkereingangsanschluss (207) und einem zweiten Verstärkereingangsanschluss (208), wobei der erste Verstärkereingangsanschluss (207) elektrisch mit dem ersten Sekundärwicklungsanschluss (204, 304) verbunden ist, der zweite Verstärkereingangsanschluss (208) elektrisch mit dem zweiten Sekundärwicklungsanschluss (205, 305) verbunden ist, und wobei der Transimpedanzverstärker (206) dafür ausgelegt ist, eine Spannung auszugeben, die einen Strom, der durch die Sekundärwicklung (203, 303) fließt, darstellt, wobei der Phasenschieber ferner umfasst:

einen ersten Phasenschiebereingangsanschluss (601) und einen zweiten Phasenschiebereein-gangsanschluss (602), die zum elektrischen Verbinden mit einer Wechselspannungsquelle ausgelegt sind;
eine erste komplexe Impedanz (603), die elektrisch zwischen dem ersten Phasenschiebereingangsanschluss (601) und dem ersten Primärwicklungsanschluss (352) verbunden ist;
eine zweite komplexe Impedanz (604), die elektrisch zwischen dem ersten Phasenschiebereingangsanschluss (601) und dem vierten Primärwicklungsanschluss (355) verbunden ist; und
Mittel (209, 210) zum Bereitstellen der Ausgangsspannung des Transimpedanzverstärkers (206) als eine Ausgangsspannung des Phasenschiebers (600);
wobei der zweite Phasenschiebereingangsanschluss (602) elektrisch mit dem zweiten Primärwicklungsanschluss (353) und dem dritten Primärwicklungsanschluss (354) verbunden ist, wobei das Messinstrument ferner umfasst:

Mittel (209, 210a) zum Anlegen der Ausgangsspannung des Schnittstellenschaltkreises (400) zwischen dem ersten Phasenschiebereingangsanschluss (601) und dem zweiten Phasenschiebereingangsanschluss (602) des Phasenschiebers (600);
einen Oszillator (705), der dafür ausgelegt ist, eine Wechselspannung bereitzustellen;
Mittel (706) zum Überlagern der Ausgangsspannung des Phasenschiebers (600) und der von dem Oszillator (705) bereitgestellten Wechselspannung, um eine Überlagerungsspannung zu bilden, und zum Anlegen der Überlagerungsspannung zwisehen dem ersten Stromquellenanschluss (401) und dem zweiten Stromquellenanschluss (402) des Schnittstellenschaltkreises (400).

6. Ein Messinstrument (700) gemäß Anspruch 5, wobei jede der ersten komplexen Impedanz (603) des Phasenschiebers (600) und der zweiten komplexen Impedanz (604) des Phasenschiebers (600) einen Kondensator (606, 607) und einen Widerstand (605, 608), die parallel geschaltet sind, umfasst.

7. Ein Messinstrument (700) gemäß Anspruch 5 oder 6, wobei mindestens eine der ersten komplexen Impedanz (603) des Phasenschiebers (600) und der zweiten komplexen Impedanz (604) des Phasenschiebers (600) eine veränderbare komplexe Impedanz ist.

8. Ein Verfahren zum Betreiben eines Messinstruments (700) mit einem Probenhalter (750) und einem Sensor (701), wobei der Sensor (701) einen Körper (710) mit einer damit verbundenen Messspitze (702) und ein elektromechanisches Element (709), das dafür ausgelegt ist, eine elastische Schwingung des Körpers (710) anzuregen, umfasst, wobei das Messinstrument (700) ferner einen Schnittstellenschaltkreis (400) gemäß einem der Ansprüche 1 bis 4 umfasst, und das elektromechanische Element (709) des Sensors elektrisch zwischen dem ersten Sensoranschluss (406) und dem zweiten Sensoranschluss (407) des Schnittstellenschaltkreises (400) verbunden ist, wobei das Verfahren umfasst:

Anlegen von einer oder mehreren ersten Wechselspannungen zwischen dem ersten Stromquellenanschluss (401) und dem zweiten Stromquellenanschluss (402) des Schnittstellenschaltkreises (400), wobei jede der einen oder mehreren ersten Wechselspannungen eine Frequenz außerhalb einer Bandbreite eines gewünschten elastischen Schwingungsmodus des Körpers (710) hat;
Anpassen der veränderbaren komplexen Impedanz (403) des Schnittstellenschaltkreises, um die Ausgangsspannung des Schnittstellenschaltkreises (400), die als Antwort auf die ein oder mehreren Wechselspannungen erhalten wird, zu verringern;
Einsetzen einer zu untersuchenden Probe (703) in den Probenhalter (750);
nach dem Anpassen der veränderbaren komplexen Impedanz (403) des Schnittstellenschaltkreises (400) und nach dem Einsetzen der zu untersuchenden Probe (703) in den Probenhalter (750), Anlegen einer zweiten Wechselspannung mit einer Frequenz innerhalb der Bandbreite des gewünschten elastischen Schwingungsmodus des Körpers (710), Abtasten einer Oberfläche der zu untersuchenden Probe (703) mit der Messspitze (702) des Sensors (701), wobei ein Abstand zwischen dem Probenhalter (750) und der Messspitze (702) anhand der Ausgangsspannung des Schnittstellenschaltkreises (400), die als Antwort auf die zweite Wechselspannung erhalten wird, gesteuert wird, und ein Größe, die den Abstand zwischen dem Probenhalter (705) und der Messspitze (702) darstellt, gemessen wird.

9. Ein Verfahren zum Betreiben eines Messinstruments (700) gemäß Anspruch 8, das ferner umfasst:

Bereitstellen eines Phasenschiebers (600), wobei der Phasenschieber (600) umfasst:

einen zweiten elektrischen Schaltkreis (300), wobei der zweite elektrische Schaltkreis umfasst:

einen Transformator (301) mit einer Sekundärwicklung (303), die einen ersten Sekundärwicklungsanschluss (304) und einen zweiten Sekundärwicklungsanschluss (305) umfasst, einer ersten Primärwicklung (350) und einer zweiten Primärwicklung (351), wobei die erste Primärwicklung (350) einen ersten Primärwicklungsanschluss (352) und einen zweiten Primärwicklungsanschluss (353) umfasst, wobei die zweite Primärwicklung (351) einen dritten Primärwicklungsanschluss (354) und einen vierten Primärwicklungsanschluss (355) umfasst, und wobei die erste Primärwicklung (350) und die zweite Primärwicklung (351) derart ausgelegt sind, dass ein elektrischer Strom, der vom ersten Primärwicklungsanschluss (352) zum zweiten Primärwicklungsanschluss (353) fließt, und ein elektrischer Strom, der vom dritten Primärwicklungsanschluss (354) zum vierten Primärwicklungsanschluss (355) fließt, in der Sekundärwicklung (303) einen Magnetfluss in der gleichen Richtung erzeugen; und
einen Transimpedanzverstärker (206) mit einem ersten Verstärkereingangsanschluss (207) und einem zweiten Verstärkereingangsanschluss (208), wobei der erste Verstärkereingangsanschluss (207) elektrisch mit dem ersten Sekundärwicklungsanschluss (204, 304) verbunden ist, und der zweite Verstärkereingangsanschluss (208) elektrisch mit dem zweiten Sekundärwicklungsanschluss (205, 305) verbunden ist, wobei der Transimpedanzverstärker (206) dafür ausgelegt ist, eine Spannung auszugeben, die einen Strom, der durch die Sekundärwicklung (203, 303) fließt, darstellt, wobei der Phasenschieber ferner umfasst:

einen ersten Phasenschiebereingangsanschluss (601) und einen zweiten Phasenschiebereingangsanschluss (602), die zum elektrischen Verbinden mit einer Wechselspannungsquelle ausgelegt sind;
eine erste komplexe Impedanz (603), die elektrisch zwischen dem ersten Phasenschiebereingangsanschluss (601) und dem ersten Primärwicklungsanschluss (352) verbunden ist;
eine zweite komplexe Impedanz (604), die elektrisch zwischen dem ersten Phasenschiebereingangsanschluss (601) und dem vierten Primärwicklungsanschluss (355) verbunden ist; und Mittel (209, 210) zum Bereitstellen der Ausgangsspannung des Transimpedanzverstärkers (206) als eine Ausgangsspannung des Phasenschiebers (600);

wobei der zweite Phasenschiebereingangsanschluss (602) elektrisch mit dem zweiten Primärwicklungsanschluss (353) und dem dritten Primärwicklungsanschluss (354) verbunden ist, und das Verfahren zum Betreiben eines Messinstruments ferner umfasst:

Anlegen der Ausgangsspannung des Schnittstellenschaltkreises (400) zwischen dem ersten Phasenschiebereingangsanschluss (601) und dem zweiten Phasenschiebereingangsanschluss (602), des Phasenschiebers (600);

Anpassen der veränderbaren komplexen Impedanz (603) des Phasenschiebers (600), um eine gewünschte Phasendifferenz zwischen der Ausgangsspannung des Phasenschiebers (600) und der Ausgangsspannung des Schnittstellenschaltkreises (400) zu erhalten;

Überlagern der Ausgangsspannung des Phasenschiebers (600) und eines Wechselstromsignals mit einer vorbestimmten Frequenz und Amplitude, um eine Überlagerungsspannung zu bilden; und

Anlegen der Überlagerungsspannung zwischen dem ersten Stromquellenanschluss (401) und dem zweiten Stromquellenanschluss (402) als die zweite Wechselspannung.

**Revendications**

1. Circuit d'interface (400, 450) pour un instrument de mesure, ledit instrument de mesure comprenant un capteur, ledit capteur comprenant un corps comportant une pointe de mesure connectée à celui-ci et un élément électromécanique adapté à exciter une oscillation élastique dudit corps, ledit circuit d'interface comprenant :

   - un premier circuit électrique (300), ledit premier circuit électrique (300) comprenant :
   - un transformateur (301) ayant un enroulement secondaire (303), ledit enroulement secondaire (303) comportant une première borne d'enroulement secondaire (304) et une deuxième borne d'enroulement secondaire (305), un premier enroulement primaire (350) et un deuxième enroulement primaire (351), ledit premier enroulement primaire (350) comportant une première borne d'enroulement primaire (352) et une deuxième borne d'enroulement primaire (353), ledit deuxième enroulement primaire (351) comportant une troisième borne d'enroulement primaire (354) et une quatrième borne d'enroulement primaire (355), dans lequel ledit premier enroulement primaire (350) et ledit deuxième enroulement primaire (351) sont adaptés à ce qu'un courant électrique circulant de ladite première borne d'enroulement primaire (352) à ladite deuxième borne d'enroulement primaire (353) et un courant électrique circulant de ladite troisième borne d'enroulement primaire (354) à ladite quatrième borne d'enroulement primaire (355) créent un flux magnétique dans la même direction dans ledit enroulement secondaire (303) ;
   - un amplificateur à transimpédance (206) comportant une première borne d'entrée d'amplificateur (207) et une deuxième borne d'entrée d'amplificateur (208), ladite première borne d'entrée d'amplificateur (207) étant électriquement connectée à ladite première borne d'enroulement secondaire (204, 304), ladite deuxième borne d'entrée d'amplificateur (208) étant électriquement connectée à ladite deuxième borne d'enroulement secondaire (205, 305), dans lequel ledit amplificateur à transimpédance (206) est adapté à délivrer en sortie une tension représentative d'un courant circulant à travers ledit enroulement secondaire (203, 303) ;
   - le circuit d'interface comprenant en outre :
   - une première borne de source d'alimentation (401) et une deuxième borne de source d'alimentation (402) adaptées à une connexion dudit circuit d'interface (400, 450) à une source d'alimentation fournissant une tension alternative ; et
   - une impédance complexe variable (403) ;
   - dans lequel ladite première borne de source d'alimentation (401) est connectée à ladite deuxième borne d'enroulement primaire (353) et à ladite troisième borne d'enroulement primaire (354) ;
   - dans lequel ladite impédance complexe variable (403) est connectée entre ladite deuxième borne de source d'alimentation (402) et ladite quatrième borne d'enroulement primaire (355) ; et
   - dans lequel ledit circuit d'interface (400, 450) comprend en outre : une première borne de capteur (406) et une deuxième borne de capteur (407) adaptées à une connexion électrique dudit élément électromécanique dudit capteur entre ladite première borne de capteur (406) et ladite deuxième borne de capteur (407), dans lequel ladite première borne de capteur (406) est électriquement connectée à ladite première borne d'enroulement primaire (352) et dans lequel ladite deuxième borne de capteur (407) est électriquement connectée à ladite deuxième borne de source d'alimentation (402) ; et
- des moyens (209, 210) pour délivrer ladite tension de sortie dudit amplificateur à transimpédance (206) en tant que tension de sortie dudit circuit d'interface (400, 450).

2. Circuit d'interface (400, 450) selon la revendication 1, dans lequel les premier (350) et deuxième (351) enroulements primaires sont constitués sous la forme de bobinages ou de parties d'un seul bobinage comportant un point milieu.

3. Circuit d'interface selon les revendications 1 ou 2, dans lequel ladite impédance complexe variable (403) comprend un condensateur variable (404) et une première résistance variable (405, 408) connectés en parallèle.

4. Circuit d'interface selon la revendication 3, comprenant en outre une deuxième résistance variable (409) électriquement connectée entre ladite première borne de capteur (406) et ladite deuxième borne de capteur (407).

5. Instrument de mesure (700) comprenant :

- un capteur (701), ledit capteur (701) comprenant un corps (710) comportant une pointe de mesure (702) connectée à celui-ci et un élément électromécanique (709) adapté à exciter une oscillation élastique dudit corps (710) ;
- un circuit d'interface (400) selon l'une quelconque des revendications 1 à 4, dans lequel ledit élément électromécanique (709) dudit capteur (701) est connecté entre ladite première borne de capteur (406) et ladite deuxième borne de capteur (407) dudit circuit d'interface (400) ;
- un déphaseur (600), ledit déphaseur (600) comprenant :
- un deuxième circuit électrique (300), ledit deuxième circuit électrique comprenant :
- un transformateur (301) ayant un enroulement secondaire (303), ledit enroulement secondaire (303) comportant une première borne d'enroulement secondaire (304) et une deuxième borne d'enroulement secondaire (305), un premier enroulement primaire (350) et un deuxième enroulement primaire (351), ledit premier enroulement primaire (350) comportant une première borne d'enroulement primaire (352) et une deuxième borne d'enroulement primaire (353), ledit deuxième enroulement primaire (351) comportant une troisième borne d'enroulement primaire (354) et une quatrième borne d'enroulement primaire (355), dans lequel ledit premier enroulement primaire (350) et ledit deuxième enroulement primaire (351) sont adaptés à ce qu'un courant électrique circulant de ladite première borne d'enroulement primaire (352) à ladite deuxième borne d'enroulement primaire (353) et un courant électrique circulant de ladite troisième borne d'enroulement primaire (354) à ladite quatrième borne d'enroulement primaire (355) créent un flux magnétique dans la même direction dans ledit enroulement secondaire (303) ;
- un amplificateur à transimpédance (206) comportant une première borne d'entrée d'amplificateur (207) et une deuxième borne d'entrée d'amplificateur (208), ladite première borne d'entrée d'amplificateur (207) étant électriquement connectée à ladite première borne d'enroulement secondaire (204, 304), ladite deuxième borne d'entrée d'amplificateur (208) étant électriquement connectée à ladite deuxième borne d'enroulement secondaire (205, 305), dans lequel ledit amplificateur à transimpédance (206) est adapté à délivrer en sortie une tension représentative d'un courant circulant à travers ledit enroulement secondaire (203, 303) ; ledit déphaseur comprenant en outre :
- une première borne d'entrée de déphaseur (601) et une deuxième borne d'entrée de déphaseur (602) adaptées à une connexion électrique à une source de tension alternative ;
- une première impédance complexe (603) électriquement connectée entre ladite première borne d'entrée de déphaseur (601) et ladite première borne d'enroulement primaire (352) ;
- une deuxième impédance complexe (604) électriquement connectée entre ladite première borne d'entrée de déphaseur (601) et ladite quatrième borne d'enroulement primaire (355) ; et
- des moyens (209, 210) pour délivrer ladite tension de sortie dudit amplificateur à transimpédance (206) en tant que tension de sortie dudit déphaseur (600) ;
- dans lequel ladite deuxième borne d'entrée de déphaseur (602) est électriquement connectée à ladite deuxième borne d'enroulement primaire (353) et à ladite troisième borne d'enroulement primaire (354) ; ledit instrument de mesure comprenant en outre :
- des moyens (209a, 210a) pour appliquer ladite tension de sortie dudit circuit d'interface (400) entre ladite première borne d'entrée de déphaseur (601) et ladite deuxième borne d'entrée de déphaseur (602) dudit déphaseur (600) ;
- un oscillateur (705) adapté à fournir une tension alternative ;
- des moyens (706) pour superposer ladite tension de sortie dudit déphaseur (600) et ladite tension alternative fournie par ledit oscillateur (705) pour former une tension de superposition et appliquer ladite tension de superposition entre ladite première borne de source d'alimentation (401) et ladite deuxième borne de source d'alimentation (402) dudit circuit d'interface (400).

6. Instrument de mesure (700) selon la revendication 5, dans lequel chacune de ladite première impédance complexe (603) dudit déphaseur (600) et de ladite deuxième impédance complexe (604) dudit déphaseur (600) comprend un condensateur (606, 607) et une résistance (605, 608) connectés en parallèle.

7. Instrument de mesure (700) selon les revendications 5 ou 6, dans lequel au moins une impédance de ladite première impédance complexe (603) dudit déphaseur (600) et de ladite deuxième impédance complexe (604) dudit déphaseur (600) est une impédance complexe variable.

8. Procédé de fonctionnement d'un instrument de mesure (700) comprenant un support d'échantillon (750), un capteur (701), ledit capteur (701) comprenant un corps (710) comportant une pointe de mesure (702) connectée à celui-ci et un élément électromécanique (709) adapté à exciter une oscillation élastique dudit corps (710), ledit instrument de mesure (700) comprenant en outre un circuit d'interface (400) selon l'une quelconque des revendications 1 à 4, dans lequel ledit élément électromécanique (709) dudit capteur est connecté entre ladite première borne de capteur (406) et ladite deuxième borne de capteur (407) dudit circuit d'interface (400), ledit procédé comprenant les étapes consistant à :

- appliquer une ou plusieurs premières tensions alternatives entre ladite première borne de source d'alimentation (401) et ladite deuxième borne de source d'alimentation (402) dudit circuit d'interface (400), chacune desdites une ou plusieurs premières tensions alternatives ayant une fréquence à l'extérieur d'une largeur de bande d'un mode d'oscillation élastique voulu dudit corps (710) ;
- régler ladite impédance complexe variable (403) dudit circuit d'interface pour réduire la tension de sortie dudit circuit d'interface (400), obtenue en réponse auxdites une ou plusieurs premières tensions alternatives ;
- insérer un échantillon (703) à étudier dans ledit support d'échantillon (750) ;
- après avoir réglé ladite impédance complexe variable (403) dudit circuit d'interface (400) et inséré ledit échantillon (703) à étudier dans ledit support d'échantillon (750), appliquer une deuxième tension alternative ayant une fréquence comprise dans ladite largeur de bande dudit mode d'oscillation élastique voulu dudit corps (710), scanner une surface dudit échantillon (703) à étudier avec ladite pointe de mesure (702) dudit capteur (701), pour lequel la distance entre ledit support d'échantillon (750) et ladite pointe de mesure (702) est commandée en fonction de la tension de sortie dudit circuit d'interface (400) obtenue en réponse à ladite deuxième tension alternative et pour lequel une quantité représentative de ladite distance entre ledit support d'échantillon (750) et ladite pointe de mesure (702) est mesurée.

9. Procédé de fonctionnement d'un instrument de mesure (700) selon la revendication 8, comprenant en outre les étapes consistant à :

- prévoir un déphaseur (600), ledit déphaseur (600) comprenant :
- un deuxième circuit électrique (300), ledit deuxième circuit électrique comprenant :
- un transformateur (301) ayant un enroulement secondaire (303), ledit enroulement secondaire (303) comportant une première borne d'enroulement secondaire (304) et une deuxième borne d'enroulement secondaire (305), un premier enroulement primaire (350) et un deuxième enroulement primaire (351), ledit premier enroulement primaire (350) comportant une première borne d'enroulement primaire (352) et une deuxième borne d'enroulement primaire (353), ledit deuxième enroulement primaire (351) comportant une troisième borne d'enroulement primaire (354) et une quatrième borne d'enroulement primaire (355), dans lequel ledit premier enroulement primaire (350) et ledit deuxième enroulement primaire (351) sont adaptés à ce qu'un courant électrique circulant de ladite première borne d'enroulement primaire (352) à ladite deuxième borne d'enroulement primaire (353) et un courant électrique circulant de ladite troisième borne d'enroulement primaire (354) à ladite quatrième borne d'enroulement primaire (355) créent un flux magnétique dans la même direction dans ledit enroulement secondaire (303) ; et
- un amplificateur à transimpédance (206) comportant une première borne d'entrée d'amplificateur (207) et une deuxième borne d'entrée d'amplificateur (208), ladite première borne d'entrée d'amplificateur (207) étant électriquement connectée à ladite première borne d'enroulement secondaire (204, 304), ladite deuxième borne d'entrée d'amplificateur (208) étant électriquement connectée à ladite deuxième borne d'enroulement secondaire (205, 305), dans lequel ledit amplificateur à transimpédance (206) est adapté à délivrer en sortie une tension représentative d'un courant circulant à travers ledit enroulement secondaire (203, 303) ; ledit déphaseur comprenant en outre :

- une première borne d'entrée de déphaseur (601) et une deuxième borne d'entrée de déphaseur (602) adaptées à une connexion électrique à une source de tension alternative ;

- une première impédance complexe (603) électriquement connectée entre ladite première borne d'entrée de déphaseur (601) et ladite première borne d'enroulement primaire (352) ;

- une deuxième impédance complexe (604) électriquement connectée entre ladite première borne d'entrée de déphaseur (601) et ladite quatrième borne d'enroulement primaire (355) ; et

- des moyens (209, 210) pour délivrer ladite tension de sortie dudit amplificateur à transimpédance (206) en tant que tension de sortie dudit déphaseur (600) ;

- dans lequel ladite deuxième borne d'entrée de déphaseur (602) est électriquement connectée à ladite deuxième borne d'enroulement primaire (353) et à ladite troisième borne d'enroulement primaire (354) ; ledit procédé de fonctionnement d'un instrument de mesure comprenant en outre les étapes consistant à :

- appliquer ladite tension de sortie dudit circuit d'interface (400) entre ladite première borne d'entrée de déphaseur (601) et ladite deuxième borne d'entrée de déphaseur (602) dudit déphaseur (600) ;

- régler ladite impédance complexe variable (603) dudit déphaseur (600) pour obtenir une différence de phase voulue entre ladite tension de sortie dudit déphaseur (600) et ladite tension de sortie dudit circuit d'interface (400) ;

- superposer ladite tension de sortie dudit déphaseur (600) et un signal alternatif ayant une fréquence et une amplitude prédéterminées pour former une tension de superposition ; et

- appliquer ladite tension de superposition entre ladite première borne de source d'alimentation (401) et ladite deuxième borne de source d'alimentation (402), en tant que ladite deuxième tension alternative.

FIG. 1
(prior art)

FIG. 2

FIG. 3

FIG. 4a

FIG. 4b

FIG. 5

FIG. 6

FIG. 7

FIG. 8

## REFERENCES CITED IN THE DESCRIPTION

**Patent documents cited in the description**

- US 5274704 A
- US 4270061 A
- EP 2120037 A1
- EP 2120036 A1
- EP 08009133 A
- EP 08009131 A
- EP 08016297 A